# EUROPEAN PATENT SPECIFICATION

(11) **EP 4 071 818 B1**
(45) Date of publication and mention of the grant of the patent: **24.06.2026**
(21) Application number: 20897017.8
(22) Date of filing: 06.11.2020
(51) Int. Cl.: H10F 39/00

(54) **SEMICONDUCTOR DEVICE AND MANUFACTURING METHOD THEREFOR**
HALBLEITERBAUELEMENT UND HERSTELLUNGSVERFAHREN DAFÜR
DISPOSITIF À SEMI-CONDUCTEUR ET SON PROCÉDÉ DE FABRICATION

(30) Priority: 02.12.2019 CN 201911215993
(43) Date of publication of application: 12.10.2022
(73) Proprietor: Wuhan Xinxin Semiconductor Manufacturing Co., Ltd., Wuhan, Hubei 430205 (CN)
(72) Inventor: HU, Sheng, Wuhan, Hubei 430205 (CN); YANG, Fan, Wuhan, Hubei 430205 (CN)
(74) Representative: Patentship Patentanwaltsgesellschaft mbH
(86) International application number: PCT/CN2020/126966
(87) International publication number: WO 2021/109794

(56) References cited:
- WO-A1-2021/109774
- CN-A- 103 403 869
- CN-A- 106 531 750
- CN-A- 107 155 375
- CN-A- 110 246 855
- CN-A- 110 783 358
- CN-A- 111 029 352
- CN-A- 111 029 353
- US-A1- 2016 204 142
- US-A1- 2017 207 270

## Description

### TECHNICAL FIELD

The present invention relates to the field of semiconductor integrated circuit fabrication and, in particular, to a semiconductor device and a method of manufacturing the device.

### BACKGROUND

During the fabrication of a back-side illuminated CMOS image sensor (BSI-CIS), the combined use of deep trench isolation (DTI) and backside metal grid (BMG) techniques enables better BSI-CIS optical properties.

However, in existing BSI-CIS fabrication processes, due to the presence of a buffer dielectric layer between a metal grid formed in a pixel region and an underlying substrate and deep trench fill structure, the metal grid can be connected to the underlying substrate and deep trench fill structure only physically but not electrically, leading to impossible optimization or improvement of the BSI-CIS's electrical performance.

Therefore, there is urgent need to modify the metal grid fabrication in the pixel region to enable electrical connection between the metal grid and the underlying substrate and/or trench fill structure and thereby obtain a semiconductor device with optimized and improved electrical performance. Documents US 2017/207270 Al and CN 107 155 375 A show examples of prior-art image sensors.

### SUMMARY OF THE INVENTION

It is an aim of the present invention to provide a semiconductor device and a method of manufacturing the semiconductor device as defined in independent claims 9 and 1, respectively. The present invention provides a method of manufacturing a semiconductor device, including:
providing a substrate with a pixel region;
forming a trench fill structure by forming a trench in the pixel region of the substrate and filling the trench with a fill material, wherein a high-k dielectric layer is sandwiched between a side wall of the fill material and the substrate;
covering the surface of the substrate in the pixel region with a buffer dielectric layer so that the trench fill structure is embedded in the buffer dielectric layer;
etching the buffer dielectric layer to form a first opening exposing at least part of the substrate around a top side wall portion of the trench fill structure and/or at least a top portion of the trench fill structure; and
forming a metal grid layer on the buffer dielectric layer so that the metal grid layer fills the first opening and is electrically connected to the exposed part of the substrate and/or the exposed portion of the trench fill structure.

Optionally, the step of forming the trench and the trench fill structure in the pixel region of the substrate may include:
covering the surface of the substrate in the pixel region with a pad oxide layer;
forming a first patterned photoresist layer on the pad oxide layer and, with the first patterned photoresist layer serving as a mask, etching through the pad oxide layer and at least a partial thickness of the substrate, thereby forming the trench in the pixel region of the substrate;
removing the first patterned photoresist layer and the pad oxide layer;
successively forming a first isolating oxide layer, the high-k dielectric layer and a second isolating oxide layer both in the trench and on the surface of the substrate;
filling the fill material in the trench in such a manner that the fill material also covers the second isolating oxide layer outside the trench; and
performing an etching or chemical mechanical polishing process to remove the fill material, the second isolating oxide layer, the high-k dielectric layer and the first isolating oxide layer above the surface of the substrate outside the trench, or to remove only the fill material above the surface of the substrate outside the trench, thereby forming the trench fill structure in the trench.

Optionally, the fill material may include a first conductive metal layer, wherein the exposure of at least a top portion of the trench fill structure in the first opening includes: exposure of the first conductive metal layer at a top side wall portion of the trench fill structure in the first opening that is so formed as to surround the top side wall portion of the trench fill structure; and/or exposure of part or the entirety of a top surface of the first conductive metal layer in the trench fill structure in the first opening that resides on a top surface of the trench fill structure.

Optionally, the step of forming the first opening by etching the buffer dielectric layer may include:
forming a second patterned photoresist layer on the buffer dielectric layer and, with the second patterned photoresist layer serving as a mask, etching the buffer dielectric layer, thereby forming the first opening in the buffer dielectric layer in the pixel region, the first opening exposing at least part of the substrate around a top side wall portion of the trench fill structure and/or at least a top portion of the trench fill structure; and
removing the second patterned photoresist layer.

Optionally, the step of forming the metal grid layer on the buffer dielectric layer may include:
forming a second conductive metal layer, which covers the buffer dielectric layer and fills up the first opening;
forming a third patterned photoresist layer on the second conductive metal layer and, with the third patterned photoresist layer serving as a mask, etching the second conductive metal layer, thus forming the metal grid layer in the pixel region, which is electrically connected to the part of the substrate and/or the portion of the trench fill structure exposed in the first opening; and
removing the third patterned photoresist layer.

Optionally, the substrate may further have a pad region peripheral to the pixel region, wherein a metal interconnection is formed in the pad region of the substrate and a plug structure above the metal interconnection, the plug structure being electrically connected at the bottom to the metal interconnection.

Optionally, the plug structure may be formed in the pad region of the substrate subsequent to the formation of the trench fill structure and prior to the covering of the surface of the substrate in the pixel region with the buffer dielectric layer.

Optionally, in the step of covering the surface of the substrate in the pixel region with the buffer dielectric layer, the buffer dielectric layer may be so formed as to further cover the surface of the substrate in the pad region so that the plug structure is embedded in the buffer dielectric layer, wherein at the same time when the first opening is formed by etching the buffer dielectric layer in the pixel region, the buffer dielectric layer in the pad region is also etched to form a second opening exposing part of a top surface of the plug structure, and wherein at the same time when the metal grid layer is formed on the buffer dielectric layer in the pixel region, a pad structure is formed on the buffer dielectric layer in the pad region so as to fill up the second opening and be electrically connected to the exposed top part of the plug structure.

The present invention also provides a semiconductor device, including:
a substrate with a pixel region, the substrate including a trench formed in the pixel region;
a trench fill structure formed in the pixel region of the substrate, the trench fill structure including a fill material filled in the trench and a high-k dielectric layer situated between a side wall of the fill material and the substrate;
a buffer dielectric layer covering the surface of the substrate in the pixel region, the buffer dielectric layer including a first opening exposing at least part of the substrate around a top side wall portion of the trench fill structure and/or at least a top portion of the trench fill structure; and
a metal grid layer formed on the buffer dielectric layer so as to fill the first opening and be electrically connected to the exposed part of the substrate and/or the exposed portion of the trench fill structure.

Optionally, the trench fill structure may include a first isolating oxide layer, the high-k dielectric layer, a second isolating oxide layer, which are sequentially stacked over a surface of the trench in the substrate, and the fill material filled in the trench, the first isolating oxide layer, the high-k dielectric layer and the second isolating oxide layer being situated at least between the side wall of the fill material and the substrate.

Optionally, the fill material may include a first conductive metal layer, wherein the exposure of at least a top portion of the trench fill structure in the first opening includes: exposure of the first conductive metal layer at a top side wall portion of the trench fill structure in the first opening that is so formed as to surround the top side wall portion of the trench fill structure; and/or exposure of part or the entirety of a top surface of the first conductive metal layer in the trench fill structure in the first opening that resides on a top surface of the trench fill structure.

Optionally, the high-k dielectric layer may have a k value of greater than 7.

Optionally, the substrate further may have a pad region peripheral to the pixel region, wherein a metal interconnection is formed in the pad region of the substrate and a plug structure above the metal interconnection, the plug structure being electrically connected at the bottom to the metal interconnection.

Optionally, a through hole may be formed in the pad region of the substrate, the through hole exposing at least part of a top surface of the metal interconnection, wherein the plug structure includes a third isolating oxide layer on a side wall of the through hole and a third conductive metal layer which fills up the through hole.

Optionally, the buffer dielectric layer may further cover the surface of the substrate in the pad region and include a second opening exposing at least a top portion of the plug structure, wherein a pad structure is formed on the buffer dielectric layer in the pad region so as to fill up the second opening and be electrically connected to the exposed top portion of the plug structure.

Embodiments of the present invention offer the following advantages over the prior art:
1. The method of the present invention includes: forming a trench fill structure in a pixel region of a substrate, wherein a high-k dielectric layer is sandwiched between a side wall of a fill material in the trench fill structure and the substrate; covering a surface of the substrate in the pixel region with a buffer dielectric layer so that the trench fill structure is embedded in the buffer dielectric layer; etching the buffer dielectric layer to form a first opening exposing at least part of the substrate around a top side wall portion of the trench fill structure and/or at least a top portion of the trench fill structure; and forming a metal grid layer on the buffer dielectric layer so that the metal grid layer fills the first opening and is electrically connected to the exposed part of the substrate and/or the exposed portion of the trench fill structure, thus resulting in optimized and improved electrical performance of the semiconductor device. Further, the high-k dielectric layer sandwiched between the side wall of the fill material and the substrate additionally optimizes the performance of the semiconductor device.
2. The semiconductor device of the present invention includes: a trench fill structure formed in a pixel region of a substrate, the trench fill structure including a fill material filled in a trench in the substrate and a high-k dielectric layer situated between a side wall of the fill material and the substrate; a buffer dielectric layer formed on a surface of the substrate in the pixel region, the buffer dielectric layer including a first opening exposing at least part of the substrate around a top side wall portion of the trench fill structure and/or at least a top portion of the trench fill structure; and a metal grid layer formed on the buffer dielectric layer, which fills the first opening and is electrically connected to the exposed part of the substrate and/or the exposed portion of the trench fill structure, thus resulting in optimized and improved electrical performance of the semiconductor device. Further, the high-k dielectric layer sandwiched between the side wall of the fill material and the substrate additionally optimizes the performance of the semiconductor device.

### BRIEF DESCRIPTION OF THE DRAWINGS

Figs. 1a to 1f are schematic illustrations of a device being fabricated in a semiconductor device fabrication process;
Fig. 2 is a flowchart of a method of manufacturing a semiconductor device according to an embodiment of the present invention;
Figs. 3a to 3i are schematic diagrams showing a device being fabricated in a first embodiment of the method of Fig. 2;
Figs. 4a to 4e are schematic diagrams showing a device being fabricated in a second embodiment of the method of Fig. 2;
Figs. 5a to 5e are schematic diagrams showing a device being fabricated in a third embodiment of the method of Fig. 2;
Figs. 6a to 6g are schematic diagrams showing a device being fabricated in a fourth embodiment of the method of Fig. 2;
Fig. 7 is a schematic diagram showing a device fabricated by a fifth embodiment of the method of Fig. 2; and
Figs. 8a to 8p are schematic diagrams showing a device being fabricated in a sixth embodiment of the method of Fig. 2.

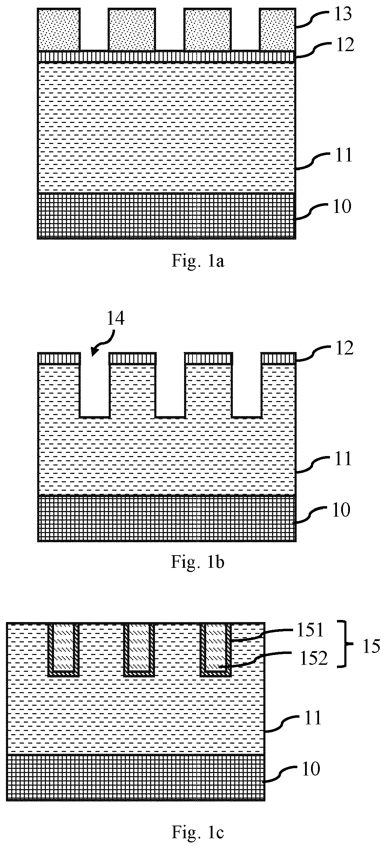

The following is a list of reference numerals used in Figs. 1a to 8p:
10-Substrate; 11-Pixel Region; 12-Pad Oxide Layer; 13-First Patterned Photoresist Layer; 14-Trench; 15-Trench Fill Structure; 151-Isolating Oxide Layer; 152-Conductive Metal Layer; 16-Buffer Oxide Layer; 17-Metal Grid Film; 18-Second Patterned Photoresist Layer; 19-Metal Grid Layer;
20-Substrate; 21-Pixel Region; 211-Trench; 212-Trench Fill Structure; 2121-First Isolating Oxide Layer; 2122-High-k Dielectric Layer; 2123-Second Isolating Oxide Layer; 2124-First Conductive Metal Layer; 2131, 2132, 2133, 2134-First Opening; 2141, 2142, 2143, 2144, 2145-Metal Grid Layer; 22-Pad region; 221-Metal interconnection; 222-Third Opening; 223-Through Hole; 224-Plug Structure; 2241-Third Isolating Oxide Layer; 2242-Third Conductive Metal Layer; 225-Second Opening; 226-Pad structure; 23-Pad Oxide Layer; 24-First Patterned Photoresist Layer; 25-Buffer Dielectric Layer; 251-First Buffer Dielectric Layer; 252-Second Buffer Dielectric Layer; 253-Third Buffer Dielectric Layer; 261, 262, 263, 264-Second Patterned Photoresist Layer; 27-Second Conductive Metal Layer; 281, 282, 283, 284-Third Patterned Photoresist Layer; 29-Fourth Patterned Photoresist Layer; 30-Fifth Patterned Photoresist Layer.

### DETAILED DESCRIPTION

A metal grid layer is made in a pixel region in the manner as detailed below.

As shown in Fig. 1a, a substrate 10 with the pixel region 11 is provided.

As shown in Figs. 1a and 1b, a pad oxide layer 12 is formed over the pixel region 11, and a first patterned photoresist layer 13 on the pad oxide layer 12. With the first patterned photoresist layer 13 serving as a mask, an etching process is performed, which proceeds through the pad oxide layer 12 in the pixel region 11 and a fractional thickness of the substrate 10, forming a trench 14 in the pixel region 11 of the substrate 10. The first patterned photoresist layer 13 is then removed.

As shown in Fig. 1c, an isolating oxide layer 151 is formed over surfaces of the trench 14 and pad oxide layer 12, and a conductive metal layer 152 is filled in the trench 14 so as to also cover the pad oxide layer 12. A chemical mechanical polishing process may be employed to remove the conductive metal layer 152, the isolating oxide layer 151 and the pad oxide layer 12 above the substrate 10, resulting in the formation of a trench fill structure 15 in the trench 14. The trench fill structure 15 includes the isolating oxide layer 151 and the conductive metal layer 152.

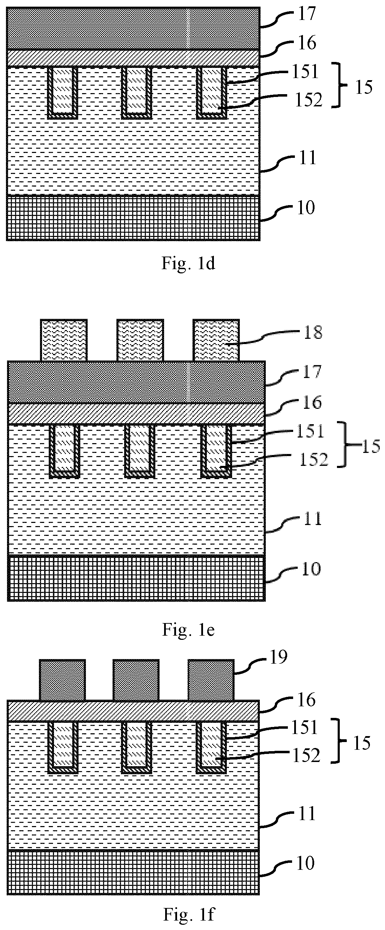

As shown in Fig. 1d, a buffer oxide layer 16 and a metal grid film 17 are successively formed over the substrate 10.

As shown in Figs. 1e and 1f, a second patterned photoresist layer 18 is formed on the metal grid film 17. With the second patterned photoresist layer 18 serving as a mask, the metal grid film 17 is etched so that the metal grid layer 19 is formed on the buffer oxide layer 16. The second patterned photoresist layer 18 is then removed. The metal grid layer 19 is located above and aligned with the trench fill structure 15.

As apparent from the description of the above steps, due to the presence of the buffer oxide layer between the metal grid layer and the underlying substrate and trench fill structure, the metal grid layer in the pixel region can be connected to the underlying substrate and trench fill structure only physically but not electrically, making it impossible to optimize or improve electrical performance of the semiconductor device. In view of this, the present invention proposes a semiconductor device and a method of manufacturing it, in which electrical connection of the metal grid layer is enabled with the underlying substrate and trench fill structure, allowing the semiconductor device to have optimized and improved electrical performance.

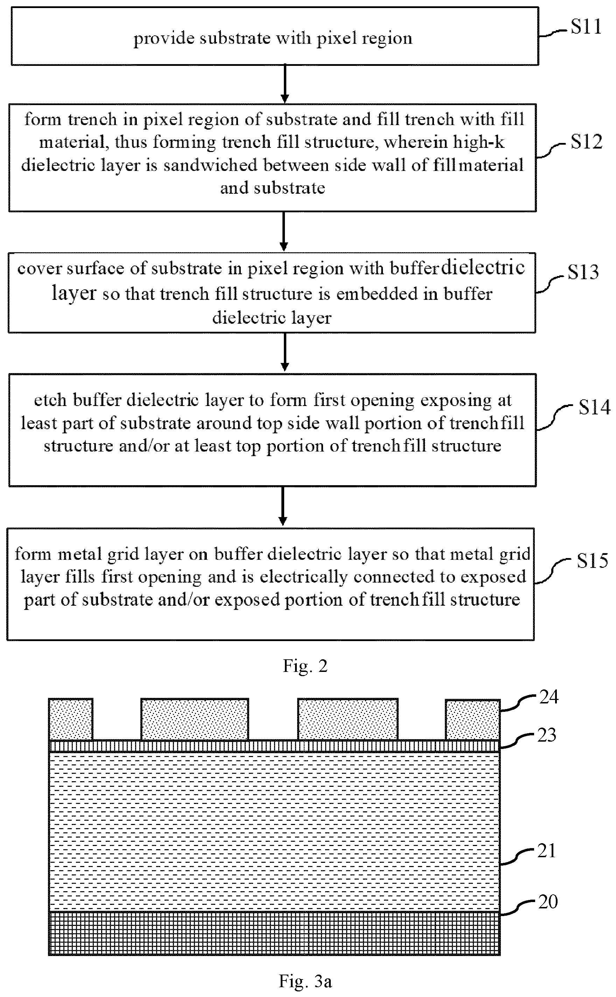

In order that objects, advantages and features of the present invention become more apparent, the semiconductor device and method proposed in the invention will be described in greater detail below with reference to Figs. 2 to 8p. Note that the drawings are provided in a very simplified form not necessarily drawn to exact scale for the only purpose of helping to explain the disclosed embodiments in a more convenient and clearer way.

In an embodiment of the present invention, there is provided a method of manufacturing a semiconductor device, which, as shown in Fig. 2, a flowchart thereof, includes the steps of:
Step S11, providing a substrate with a pixel region;
Step S12, forming a trench in the pixel region of the substrate and filling the trench with a fill material, thus forming a trench fill structure, wherein a high-k dielectric layer is sandwiched between a side wall of the fill material and the substrate;
Step S13, covering a surface of the substrate in the pixel region with a buffer dielectric layer so that the trench fill structure is embedded in the buffer dielectric layer;
Step S14, etching the buffer dielectric layer to form a first opening exposing at least part of the substrate around a top side wall portion of the trench fill structure and/or at least a top portion of the trench fill structure; and
Step S15, forming a metal grid layer on the buffer dielectric layer so that the metal grid layer fills the first opening and is electrically connected to the exposed part of the substrate and/or the exposed portion of the trench fill structure.

A more detailed description of the method of the present invention is set forth below with reference to Figs. 3a-8p, which are all schematic longitudinal cross-sectional views of the semiconductor device being fabricated.

In step S11, a substrate 20 with a pixel region 21 is provided. The substrate 20 may be any suitable material well known to those skilled in the art. For example, it may be at least one of silicon (Si), germanium (Ge), germanium silicon (SiGe), semiconductor on insulator (SOI), silicon carbide (SiC), germanium silicon carbide (SiGeC), indium arsenide (InAs), gallium arsenide (GaAs), indium phosphide (InP) or other III-V compound semiconductors.

In step S2, a trench 211 is formed in the pixel region 21 of the substrate 20, and a fill material is filled in the trench 211, thus forming a trench fill structure 212. A high-k dielectric layer 2122 is sandwiched between a side wall of the fill material and the substrate 20.

The trench 211 may be a deep trench with a depth of 1-5 µm. It is to be noted that the depth of the trench 211 is not limited to being within the above range and may be appropriately determined according to performance requirements for the semiconductor device. The trench fill structure 212 may serve to isolate components in the pixel region 21 of the substrate 20. The high-k dielectric layer 2122 is preferred to have a k (dielectric permittivity) value of greater than 7. Materials from which the high-k dielectric layer 2122 can be made may include, but are not limited to, nitrides or metal oxides such as silicon nitride, silicon oxynitride, titanium dioxide, tantalum pentoxide, etc. The high-k dielectric layer 2122 operates at a voltage in a different band and has different charge properties and can thus change the charge in the substrate 20 and reduce a dark current that may produce noise harmful to the performance of the semiconductor device.

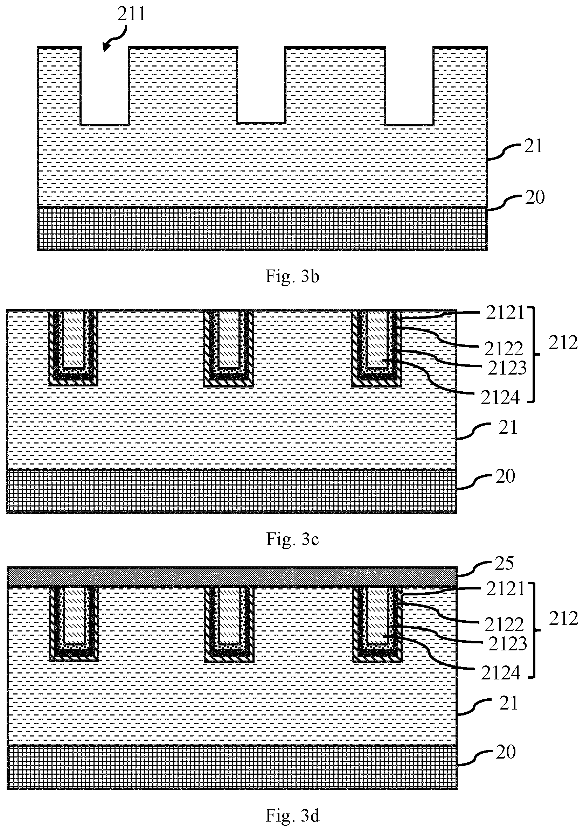

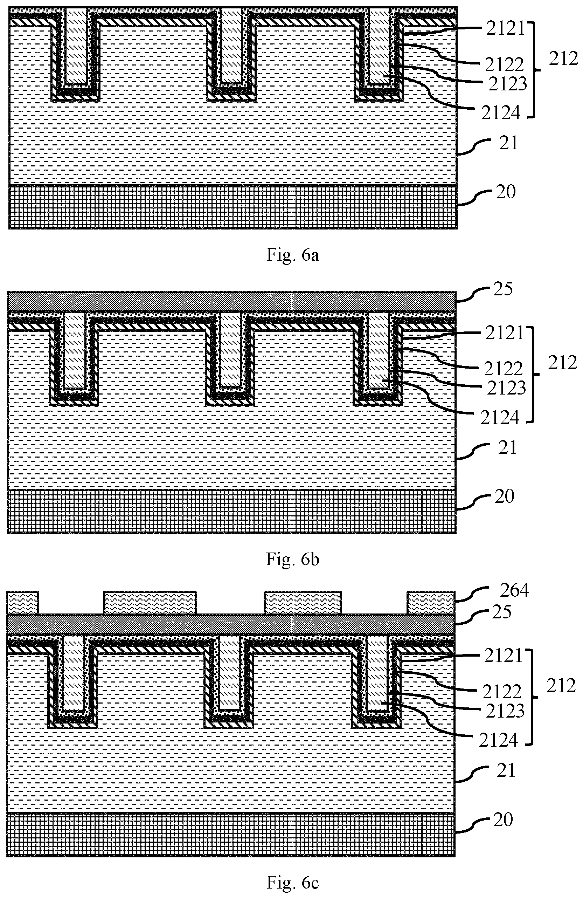

The step in which the trench 211 and the trench fill structure 212 are formed in the pixel region 21 of the substrate 20 includes: first, as shown in Fig. 3a, covering a surface of the substrate 20 in the pixel region 21 with a pad oxide layer 23, which is intended to protect the surface of the substrate 20 during the subsequent photolithographic formation of the first patterned photoresist layer 24; then, as shown in Figs. 3a and 3b, forming the first patterned photoresist layer 24 on the pad oxide layer 23 and, with the first patterned photoresist layer 24 serving as a mask, etching through the pad oxide layer 23 and at least a partial thickness of the substrate 20 in the pixel region 21, thereby forming the trench 211 in the pixel region 21 of the substrate 20; subsequently, removing the first patterned photoresist layer 24 and the pad oxide layer 23; next, successively forming a first isolating oxide layer 2121, the high-k dielectric layer 2122 and a second isolating oxide layer 2123 both in the trench 211 and over the surface of the substrate 20, wherein the first isolating oxide layer 2121, the high-k dielectric layer 2122 and the second isolating oxide layer 2123 in the trench 211 may reside either only on a side wall of the trench 211 or on both the side wall and a bottom wall of the trench 211; afterwards, filling the fill material in the trench 211 so that it also covers the second isolating oxide layer 2123 surrounding the trench 211; and then performing an etching or chemical mechanical polishing process to remove the fill material, the second isolating oxide layer 2123, the high-k dielectric layer 2122 and the first isolating oxide layer 2121 above the surface of the substrate 20 around the trench 211 (as shown in Fig. 3c), or only the fill material above the surface of the substrate 20 around the trench 211 (as shown in Fig. 6a), thus forming the trench fill structure 212 in the trench 211. In Fig. 6a, the first isolating oxide layer 2121, the high-k dielectric layer 2122 and second isolating oxide layer 2123 are shown as remaining over the substrate 20.

The fill material may include a dielectric material, or a metallic material, or both. When the fill material is a metallic material, as shown in Fig. 3c, the trench fill structure 212 includes the first isolating oxide layer 2121, the high-k dielectric layer 2122 and the second isolating oxide layer 2123, all formed over the surface of the trench 211, and a first conductive metal layer 2124 that fills up the trench 211 (i.e., the fill material provides the first conductive metal layer 2124). The dielectric material may include at least one of silica, silicon nitride, ethyl silicate, borosilicate glass, phosphosilicate glass, boro-phospho-silicate glass and silicon oxynitride, and the metallic material may include at least one of tungsten, nickel, aluminum, silver, gold and titanium.

Additionally, a top surface of the trench fill structure 212 may be flush with the top surface of the substrate 20. Alternatively, the top surface of the trench fill structure 212 may be higher than the top surface of the substrate 20. Alternatively, only a top surface of the fill material in the trench fill structure 212 may be higher than the top surface of the substrate 20.

In step S13, the surface of the substrate 20 in the pixel region 21 is covered with a buffer dielectric layer 25 so that the trench fill structure 212 is embedded in the buffer dielectric layer 25, as shown in Fig. 3d. The buffer dielectric layer 25 may be formed of a material including at least one of silica, silicon nitride, ethyl silicate, borosilicate glass, phosphosilicate glass, boro-phospho-silicate glass and silicon oxynitride. As shown in Figs. 6a and 6b, if only the fill material above the surface of the substrate 20 around the trench 211 is removed, with the first isolating oxide layer 2121, the high-k dielectric layer 2122 and the second isolating oxide layer 2123 still remaining above the surface of the substrate 20, then it can be interpreted that the first isolating oxide layer 2121, the high-k dielectric layer 2122 and the second isolating oxide layer 2123 form part of the buffer dielectric layer 25.

In step S14, the buffer dielectric layer 25 is etched to form a first opening exposing at least part of the substrate 20 around a top side wall portion of the trench fill structure 212, at least a top portion of the trench fill structure 212, or both.

The exposure of at least part of the substrate 20 around a top side wall portion of the trench fill structure 212 in the first opening 214 means that the first opening is so formed as to at least surround the top of the trench fill structure 212 so that at least part of the substrate 20 around the top of the trench fill structure 212 is exposed.

The exposure of at least a top portion of the trench fill structure 212 in the first opening 214 may include: when the top surface of the trench fill structure 212 is raised over the top surface of the substrate 20, and if the first opening surrounds only the top side wall portion of the trench fill structure 212 so that the first isolating oxide layer 2121 is exposed at the top side wall portion of the trench fill structure 212, exposure of also part of the substrate 20 around the top side wall portion of the trench fill structure 212 in the first opening 214; when only the top surface of the fill material in the trench fill structure 212 is raised over the top surface of the substrate 20, and if the first opening 214 surrounds only the top side wall portion of the trench fill structure 212, exposure of the fill material in the trench fill structure 212 at the top side wall portion; when the top surface of the trench fill structure 212 is raised over or flush with the top surface of the substrate 20, and if the first opening 214 resides on the top surface of the trench fill structure 212, exposure of part or the entirety of the top surface of the trench fill structure 212, including exposure of part or the entirety of the top surface of the fill material, or exposure of both part or the entirety of the top surface of the fill material and part or the entirety of top surface(s) of the first isolating oxide layer 2121 and/or the high-k dielectric layer 2122 and/or the second isolating oxide layer 2123; and when the top surface of the trench fill structure 212 is raised over the top surface of the substrate 20, exposure of both the first isolating oxide layer 2121, the high-k dielectric layer 2122, the second isolating oxide layer 2123 or the fill material in the trench fill structure 212 at the top side wall portion and part or the entirety of the top surface of the trench fill structure 212.

When the fill material includes the first conductive metal layer 2124, the exposure of at least a top portion of the trench fill structure 212 in the first opening 214 may include: exposure of the first conductive metal layer 2124 at the top side wall portion of the trench fill structure 212 in the first opening 214 that is so formed as to surround the top side wall portion of the trench fill structure 212; or exposure of part or the entirety of the top surface of the first conductive metal layer 2124 in the trench fill structure 212 in the first opening 214 that resides on the top surface of the trench fill structure 212; or exposure of both the first conductive metal layer 2124 in the trench fill structure 212 at the top side wall portion and part or the entirety of the top surface of the first conductive metal layer 2124 in the trench fill structure 212 in the first opening 214.

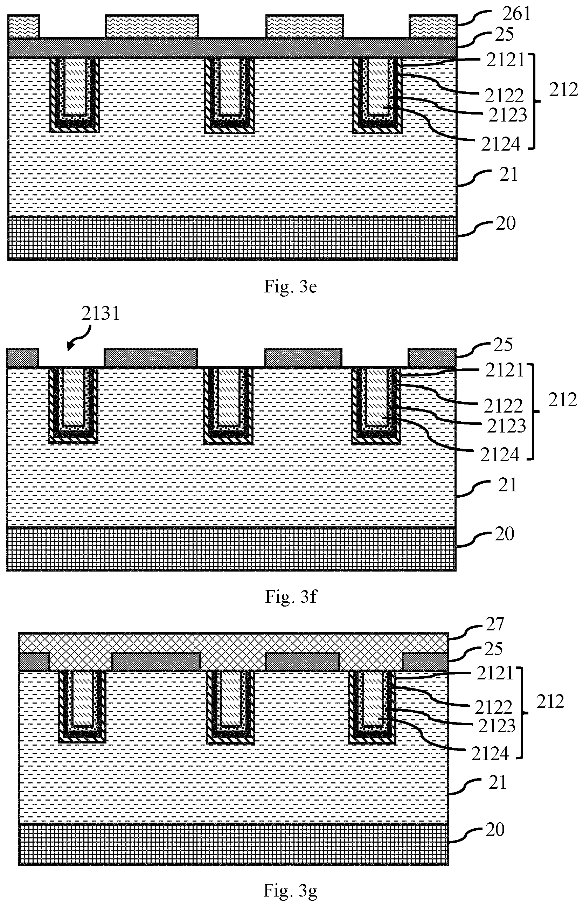

Different methods for forming the first opening in the above various scenarios of exposure of the underlying structure in the first opening will be exemplified below. Figs. 3e to 3i, Figs. 4a to 4e and Figs. 5a to 5e show the scenarios where the top surface of the trench fill structure 212 is flush with the top surface of the substrate 20. Figs. 6c to 6g show the scenario where the top surface of the trench fill structure 212 is raised over the top surface of the substrate 20, with the first isolating oxide layer 2121, the high-k dielectric layer 2122 and the second isolating oxide layer 2123 remaining above the substrate 20.

Referring to Figs. 3e to 3f, the formation of the first opening 2131 may include the steps of: forming a second patterned photoresist layer 261 on the buffer dielectric layer 25 (as shown in Fig. 3e); with the second patterned photoresist layer 261 serving as a mask, etching the buffer dielectric layer 25, thus forming the first opening 2131 in the buffer dielectric layer 25 in the pixel region 21, in which part of the substrate 20 around a top side wall portion of the trench fill structure 212 and the entire top surface of the trench fill structure 212 are exposed, as shown in Fig. 3f.

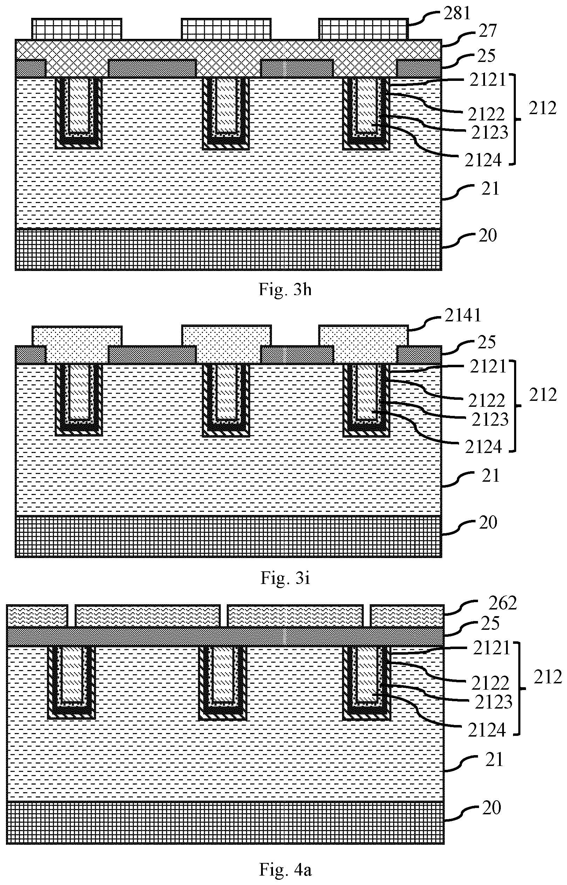

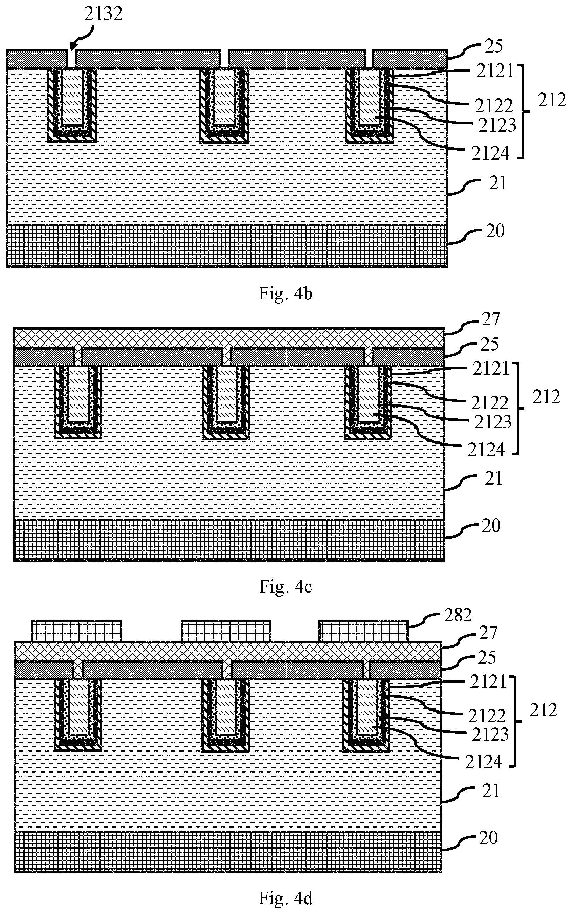

Alternatively, referring to Figs. 4a to 4b, the formation of the first opening 2132 may include the steps of: forming a second patterned photoresist layer 262 on the buffer dielectric layer 25 (as shown in Fig. 4a); and with the second patterned photoresist layer 262 serving as a mask, etching the buffer dielectric layer 25, thus forming the first opening 2132 in the buffer dielectric layer 25 in the pixel region 21, in which part of the top surface of the trench fill structure 212, such as part of the top surface of the fill material, is exposed, as shown in Fig. 4b. If the fill material is the first conductive metal layer 2124, then part of the top surface of the first conductive metal layer 2124 in the trench fill structure 212 is exposed in the first opening 2132.

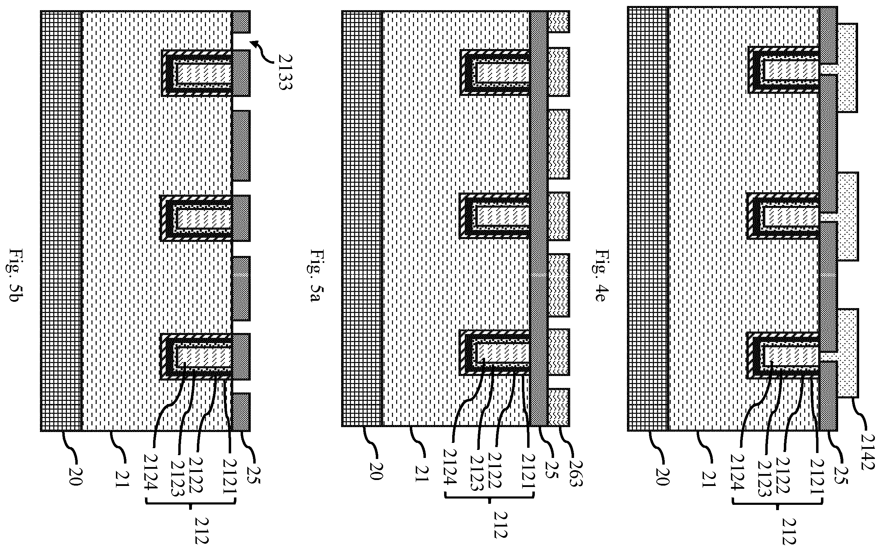

Alternatively, referring to Fig. 5a to 5b, the formation of the first opening 2133 may include the steps of: forming a second patterned photoresist layer 263 on the buffer dielectric layer 25 (as shown in Fig. 5a); and with the second patterned photoresist layer 263 serving as a mask, etching the buffer dielectric layer 25, thus forming the first opening 2133 in the buffer dielectric layer 25 in the pixel region 21, as shown in Fig. 5b, in which part of the substrate 20 around a top side wall portion of the trench fill structure 212 is exposed.

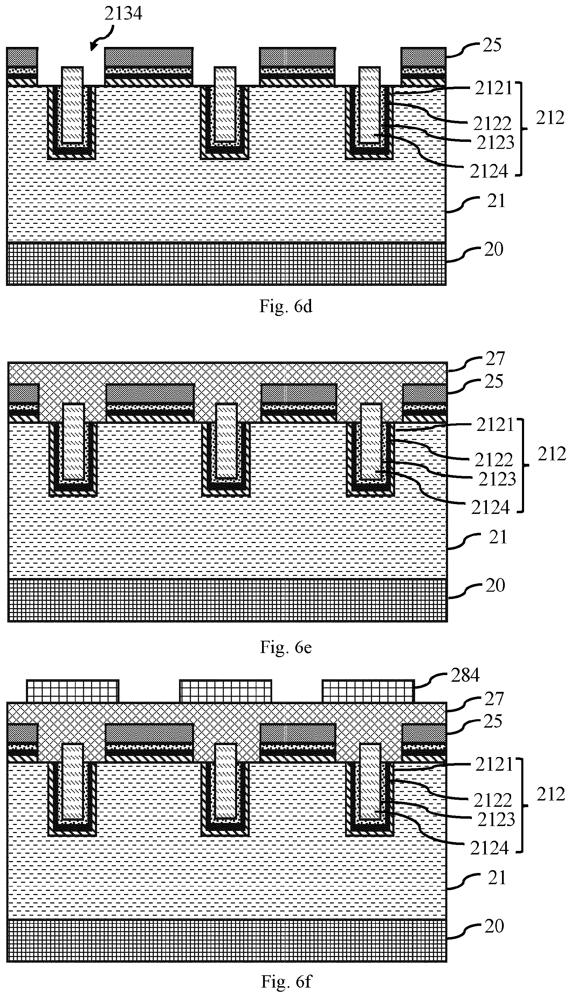

Alternatively, referring to Fig. 6c to 6d, the formation of the first opening 2134 may include the steps of: forming a second patterned photoresist layer 264 on the buffer dielectric layer 25 (as shown in Fig. 6c); and with the second patterned photoresist layer 264 serving as a mask, etching the buffer dielectric layer 25, the second isolating oxide layer 2123, the high-k dielectric layer 2122 and the first isolating oxide layer 2121 over the substrate 20, thus forming the first opening 2134 in the buffer dielectric layer 25 in the pixel region 21, in which part of the substrate 20 around a top side wall portion of the trench fill structure 212 and the entire top surface of the trench fill structure 212 are exposed. As shown in Fig. 6d, the etched first conductive metal layer 2124 remains raised over the substrate 20, and therefore a top side wall portion of the first conductive metal layer 2124 is also exposed in the first opening 2134.

The second patterned photoresist layer is removed after the formation of the first opening.

In step S 15, a metal grid layer is formed on the buffer dielectric layer 25 so as to fill the first opening and be electrically connected to the exposed part of the substrate 20, the exposed portion of the trench fill structure 212, or both.

Electrically connecting the metal grid layer to the exposed part of the substrate 20 and/or the exposed portion of the trench fill structure 212 can optimize and improve electrical performance, such as dark current performance, of the semiconductor device. Moreover, the high-k dielectric layer 2122 can additionally reduce the dark current in the semiconductor device, resulting in further optimization and improvement of the semiconductor device's electrical performance.

When only part of the substrate 20 is exposed in the first opening, the metal grid layer is electrically connected to only the exposed part of the substrate 20. When at least a top portion of the trench fill structure 212 is exposed in the first opening, in consistence with the scenarios enumerated in connection with the description of step S 14, the electrical connection of the metal grid layer with the underlying structure includes: when the top surface of the trench fill structure 212 is raised over the top surface of the substrate 20, and if the first opening surrounds only a top side wall portion of the trench fill structure 212 (i.e., the first isolating oxide layer 2121 is exposed at the top side wall portion), electrical connection of the metal grid layer also with only the exposed part of the substrate 20; when only the top surface of the fill material in the trench fill structure 212 is raised over the top surface of the substrate 20 and the first opening surrounds only a top side wall portion of the trench fill structure 212, and if the fill material is the first conductive metal layer 2124, electrical connection of the metal grid layer with the first conductive metal layer 2124 at the top side wall portion of the trench fill structure 212; when the top surface of the trench fill structure 212 is raised over or flush with the top surface of the substrate 20 and the first opening 214 resides on the top surface of the fill material in the trench fill structure 212, and if the fill material is the first conductive metal layer 2124, electrical connection of the metal grid layer with the partially or entirely exposed top surface of the first conductive metal layer 2124 in the trench fill structure 212; when the top surface of the trench fill structure 212 is raised over the top surface of the substrate 20, and if the first opening 214 exposes both the isolating oxide layer 2121 or the first conductive metal layer 2124 at a top side wall portion of the trench fill structure 212 and part or the entirety of the top surface of the first conductive metal layer 2124, electrical connection of the metal grid layer with both the part of the substrate 20 and the first conductive metal layer 2124.

In consistence with the various scenarios of exposure of the underlying structure in the first opening in step S14, methods for forming the metal grid layer on the buffer dielectric layer 25 corresponding to the different method of forming the first opening may include those as detailed below.

Referring to Figs. 3g to 3i, the formation of the metal grid layer 2141 on the buffer dielectric layer 25 may include the steps of: at first, as shown in Fig. 3g, forming a second conductive metal layer 27 over the buffer dielectric layer 25 so that the second conductive metal layer 27 fills up the first opening 2131; and then forming a third patterned photoresist layer 281 on the second conductive metal layer 27 (as shown in Fig. 3h) and, with the third patterned photoresist layer 281 serving as a mask, etching the second conductive metal layer 27, thus forming the metal grid layer 2141 in the pixel region 21 (as shown in Fig. 3i). The metal grid layer 2141 is electrically connected to the part of the substrate 20 around the top side wall portion of the trench fill structure 212 and the entire top surface of the trench fill structure 212 (i.e., the top surface of all the conductive material in the trench fill structure 212) both exposed in the first opening 2131.

Alternatively, referring to Figs. 4c to 4e, the formation of the metal grid layer 2142 on the buffer dielectric layer 25 may include the steps of: at first, as shown in Fig. 4c, forming a second conductive metal layer 27 over the buffer dielectric layer 25 so that the second conductive metal layer 27 fills up the first opening 2132; and then forming a third patterned photoresist layer 282 on the second conductive metal layer 27 (as shown in Fig. 4d) and, with the third patterned photoresist layer 282 serving as a mask, etching the second conductive metal layer 27, thus forming the metal grid layer 2142 in the pixel region 21 (as shown in Fig. 4e). The metal grid layer 2142 is electrically connected to the part of the top surface of the first conductive metal layer 2124 in the trench fill structure 212 exposed in the first opening 2132.

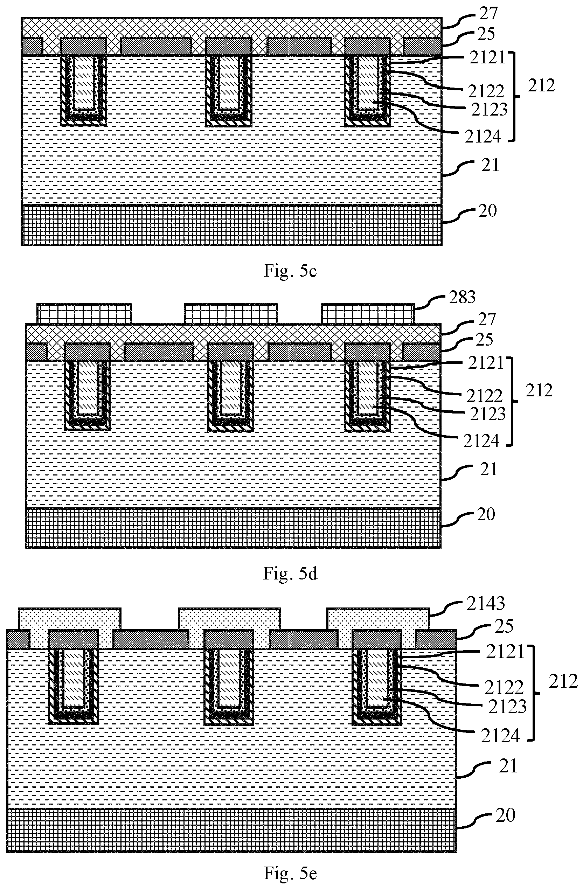

Alternatively, referring to Figs. 5c to 5e, the formation of the metal grid layer 2143 on the buffer dielectric layer 25 may include the steps of: at first, as shown in Fig. 5c, forming a second conductive metal layer 27 over the buffer dielectric layer 25 so that the second conductive metal layer 27 fills up the first opening 2133; and then forming a third patterned photoresist layer 283 on the second conductive metal layer 27 (as shown in Fig. 5d) and, with the third patterned photoresist layer 283 serving as a mask, etching the second conductive metal layer 27, thus forming the metal grid layer 2143 in the pixel region 21 (as shown in Fig. 5e). The metal grid layer 2143 is electrically connected to the part of the substrate 20 around the top side wall portion of the trench fill structure 212 exposed in the first opening 2133.

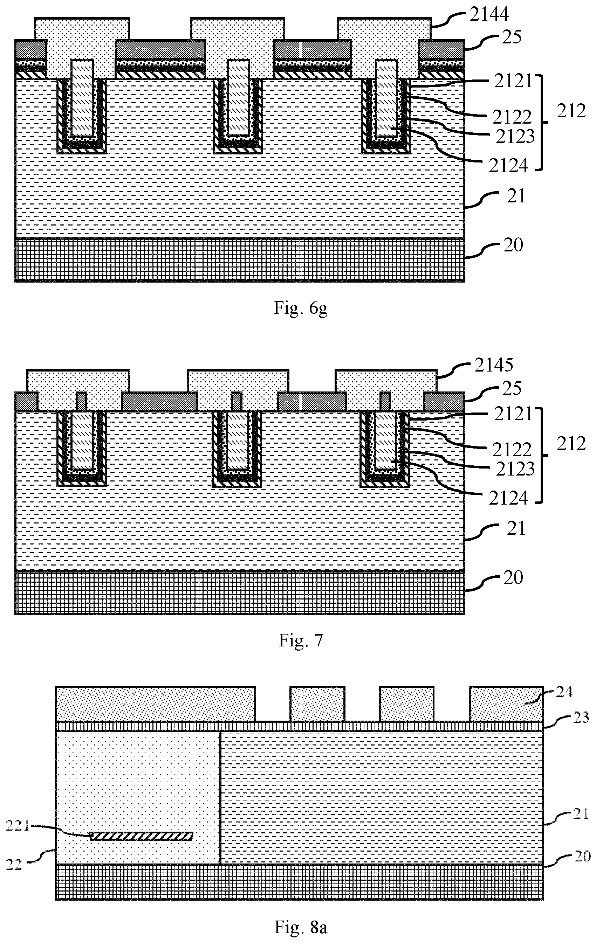

Alternatively, referring to Figs. 6e to 6g, the formation of the metal grid layer 2144 on the buffer dielectric layer 25 may include the steps of: at first, as shown in Fig. 6e, forming a second conductive metal layer 27 over the buffer dielectric layer 25 so that the second conductive metal layer 27 fills up the first opening 2134; and then forming a third patterned photoresist layer 284 on the second conductive metal layer 27 (as shown in Fig. 6f) and, with the third patterned photoresist layer 284 serving as a mask, etching the second conductive metal layer 27, thus forming the metal grid layer 2144 in the pixel region 21 (as shown in Fig. 6g). The metal grid layer 2144 is electrically connected to the part of the substrate 20 around the top side wall portion of the trench fill structure 212 and the entire top surface of the trench fill structure 212, both exposed in the first opening 2134, and is in contact with the top side wall portion of the first conductive metal layer 2124.

Further, the third patterned photoresist layer is removed after the formation of the metal grid layer. The second conductive metal layer 27 may be formed of a material including at least one of nickel, aluminum, silver, gold, titanium and copper.

In addition, as shown in Fig. 7, the metal grid layer 2145 may also be electrically connected to part of the substrate 20 around a top side wall portion of the trench fill structure 212 and part of the top surface of the first conductive metal layer 2124 in the trench fill structure 212, both exposed in the first opening.

The substrate further has a pad region peripheral to the pixel region. In the pad region of the substrate, a metal interconnection and a plug structure overlying the metal interconnection are formed. The plug structure is electrically connected at the bottom to the metal interconnection, and at the top to a pad structure. It is to be noted that another metal structure than the metal interconnection may be formed in the pad region of the substrate so as to be electrically connected to the bottom of the plug structure. For example, the metal structure may be a conductive contact plug electrically connected to the bottom of the plug structure. These metal structures are exemplified below by the metal interconnection.

If the high-k dielectric layer is formed in the plug structure in the pad region, the device will have increased capacitance, which will lead to a significant transmission delay (RC delay) and degradation in the performance of the semiconductor device. Therefore, the high-k dielectric layer shall not be formed in the plug structure in the pad region. Accordingly, separate formation of the trench fill structure in the pixel region and the plug structure in the pad region is necessary.

The formation of the various features in the pad region may include the steps of: subsequent to the formation of the trench fill structure and prior to the formation of the buffer dielectric layer over the surface of the substrate in the pixel region, forming the plug structure in the pad region of the substrate; forming the buffer dielectric layer on the surface of the substrate in the pixel region in such a manner that it also covers the surface of the substrate in the pad region so that the plug structure is buried in the buffer dielectric layer; at the same time when the first opening is formed by etching the buffer dielectric layer in the pixel region, further etching the buffer dielectric layer in the pad region to form a second opening in which part of a top surface of the plug structure is exposed; and at the same time when the metal grid layer is formed on the buffer dielectric layer in the pixel region, forming the pad structure on the buffer dielectric layer in the pad region so that the pad structure fills the second opening and is electrically connected to the exposed top portion of the plug structure.

Steps involved in the formation of the trench fill structure and the metal grid layer in the pixel region and the plug structure and the pad structure in the pad region will be described below with reference to Figs. 8a to 8p. Reference can be made to the above description of steps S11 to S15 for details in the various scenarios of electrical connection between the metal grid layer in the pixel region and the exposed part of the substrate and/or the exposed portion of the trench fill structure, and a further description thereof is omitted here. Taking the scenario shown in Figs. 6a to 6g, where the metal grid layer 2144 is electrically connected to part of the substrate 20 around a top side wall portion of the trench fill structure 212 and the entire top surface of the trench fill structure 212, both exposed in the first opening 2134, as an example, the formation of the trench fill structure 212 and the metal grid layer 2144 in the pixel region 21 and the plug structure 224 and the pad structure 226 in the pad region 22 may include the steps as follows.

Referring to Fig. 8a, in step S21, a substrate 20 with a pixel region 21 and a pad region 22 is provided. The pad region 22 is peripheral to the pixel region 21. A metal interconnection 221 is formed in the pad region 22 of the substrate 20.

Referring to Figs. 8a to 8c, in step S22, a trench 211 is formed in the pixel region 21 of the substrate 20, and a fill material is filled in the trench 211, thus forming a trench fill structure 212. A high-k dielectric layer 2122 is sandwiched between a side wall of the fill material and the substrate 20.

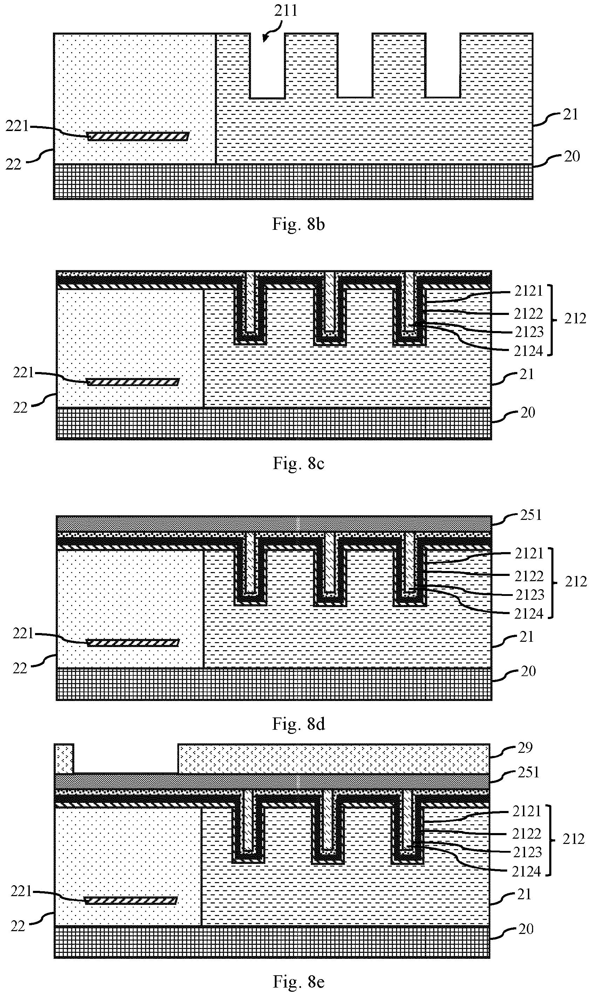

The step in which the trench 211 and the trench fill structure 212 are formed in the pixel region 21 of the substrate 20 includes: first, as shown in Fig. 8a, covering a surface of the substrate 20 in the pixel region 21 and the pad region 22 with a pad oxide layer 23, which is intended to protect the surface of the substrate 20 during the subsequent photolithographic formation of the first patterned photoresist layer 24; then, as shown in Figs. 8a and 8b, forming the first patterned photoresist layer 24 on the pad oxide layer 23 and, with the first patterned photoresist layer 24 serving as a mask, etching through the pad oxide layer 23 and at least a partial thickness of the substrate 20 in the pixel region 21, thereby forming the trench 211 in the pixel region 21 of the substrate 20; subsequently, removing the first patterned photoresist layer 24 and the pad oxide layer 23; next, successively forming a first isolating oxide layer 2121, the high-k dielectric layer 2122 and a second isolating oxide layer 2123 both in the trench 211 and over the surface of the substrate 20 and filling a first conductive metal layer 2124 (i.e., the fill material) in the trench 211 so that it also covers the second isolating oxide layer 2123 surrounding the trench 211; and then performing an etching or chemical mechanical polishing process to remove the first conductive metal layer 2124 above the surface of the substrate 20 around the trench 211, thus forming the trench fill structure 212 in the trench 211. As shown in Fig. 8c, the first isolating oxide layer 2121, the high-k dielectric layer 2122 and the second isolating oxide layer 2123 remain over the substrate 20, and the top surface of the trench fill structure 212 is raised over the top surface of the substrate 20.

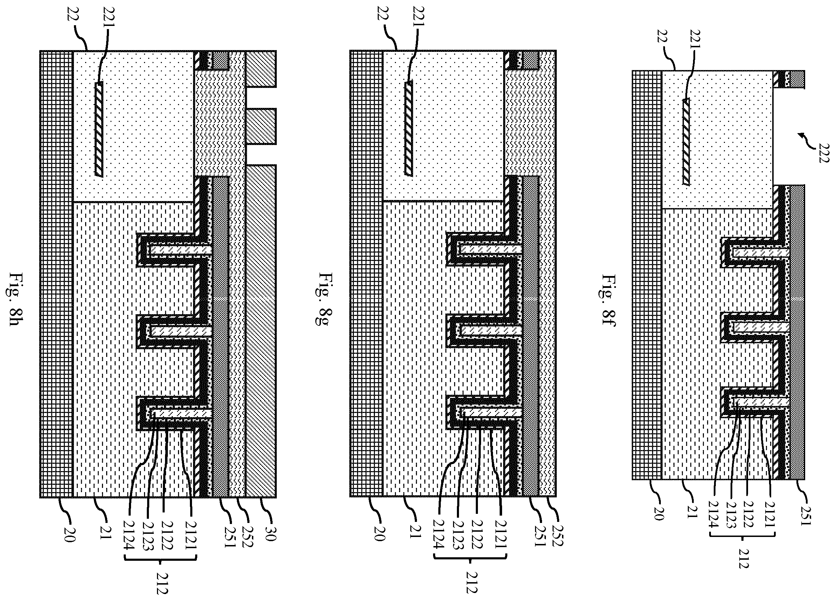

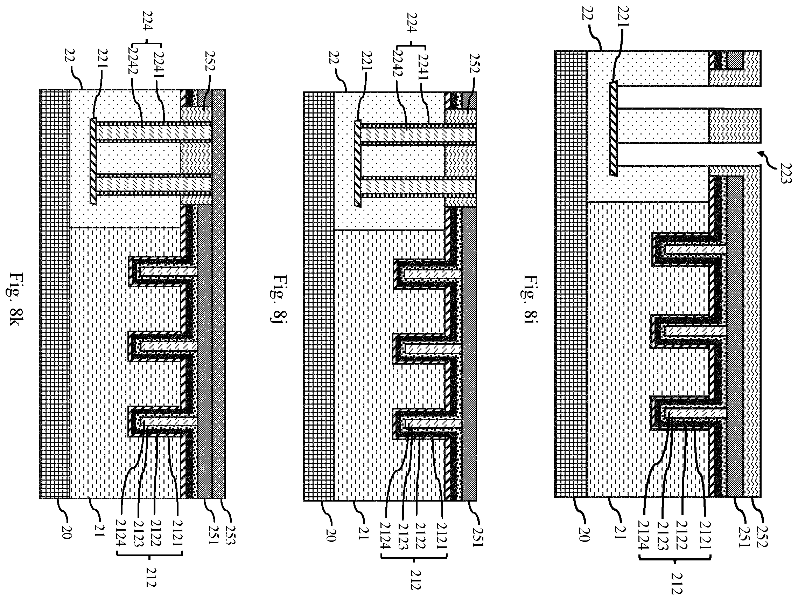

Referring to Figs. 8d to 8j, in step S23, a plug structure 224 is formed in the pad region 22 of the substrate 20. The formation may include the steps of: first of all, as shown in Fig. 8d, covering the surface of the substrate 20 in the pixel region 21 and the pad region 22 with a first buffer dielectric layer 251 so that the trench fill structure 212 is embedded in the first buffer dielectric layer 251; subsequently, forming a fourth patterned photoresist layer 29 on the first buffer dielectric layer 251 (as shown in Fig. 8e) and, with the fourth patterned photoresist layer 29 serving as a mask, etching through the first buffer dielectric layer 251, the second isolating oxide layer 2123, the high-k dielectric layer 2122 and the first isolating oxide layer 2121 in the pad region 22, thus forming a third opening 222 in the first buffer dielectric layer 251 in the pad region 22 (as shown in Fig. 8f), the third opening 222 exposing part of the top surface of the substrate 20 above the metal interconnection 221; next, as shown in Fig. 8g, filling a second buffer dielectric layer 252 in the third opening 222 so that the second buffer dielectric layer 252 also covers the first buffer dielectric layer 251; after that, forming a fifth patterned photoresist layer 30 on the second buffer dielectric layer 252 (as shown in Fig. 8h) and, with the fifth patterned photoresist layer 30 serving as a mask, etching through the second buffer dielectric layer 252 and at least a partial thickness of the substrate 20 in the third opening 222, thus forming a through hole 223 extending through the second buffer dielectric layer 252 into the substrate 20 in the pad region 22, as shown in Fig. 8i, the through hole 223 exposing at least part of a top surface of the metal interconnection 221; then, forming a third isolating oxide layer 2241 on a side wall of the through hole 223 in such a manner that the third isolating oxide layer 2241 further covers the substrate 20; following that, filling up the through hole 223 with a third conductive metal layer 2242 which further covers the third isolating oxide layer 2241 around the through hole 223; and afterwards, performing an etching or chemical mechanical polishing process to remove the third conductive metal layer 2242 and the third isolating oxide layer 2241 above the substrate 20 around the through hole 223, thus forming the plug structure 224. The third conductive metal layer 2242 in the plug structure 224 is electrically connected at the bottom to the metal interconnection 221, as shown in Fig. 8j.

According to embodiments of the present application, forming the through hole 223 extending through the second buffer dielectric layer 252 into the substrate 20 in the pad region 22 by first forming the third opening 222 exposing part of the top surface of the substrate 20 above the metal interconnection 221, then filling the third opening 222 with the second buffer dielectric layer 252 that also covers the first buffer dielectric layer 251 and then etching through the second buffer dielectric layer 252 and at least a partial thickness of the substrate 20 in the third opening 222 enables higher accuracy and reliability of the etching processes involved in the formation of the through hole 223. In other embodiments of this application, it is also possible to directly form the through hole 223 by etching through the first buffer dielectric layer 251 and at least a partial thickness of the substrate 20, without forming the third opening 222. This can simplify the fabrication process.

Referring to Fig. 8k, in step S24, a third buffer dielectric layer 253 is formed over the surface of the substrate 20 in the pixel region 21 and the pad region 22 so as to embed the plug structure 224. As shown in Fig. 8k, it will be appreciated that the first isolating oxide layer 2121, the high-k dielectric layer 2122, the second isolating oxide layer 2123, the first buffer dielectric layer 251, the second buffer dielectric layer 252 and the third buffer dielectric layer 253, which are laminated over the substrate 20 so as to bury the trench fill structure 212 and the plug structure 224, make up the aforementioned buffer dielectric layer 25.

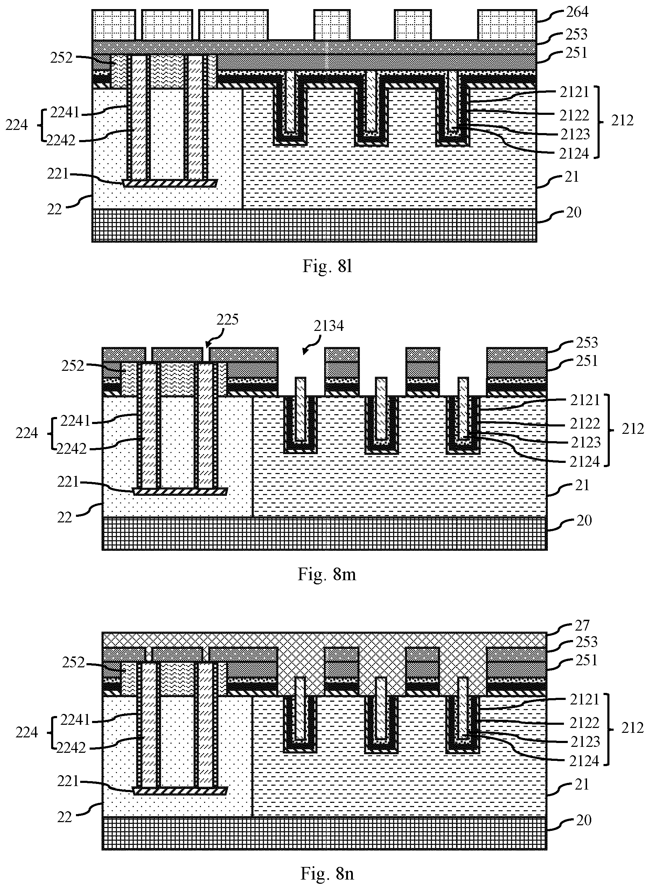

Referring to Figs. 8l to 8m, in step S25, the buffer dielectric layer is etched to form therein a first opening 2134 in the pixel region 21 and a second opening 225 in the pad region 22. Part of the substrate 20 around a top side wall portion of the trench fill structure 212 and the entire top surface of the trench fill structure 212 are exposed in the first opening 2134, and part of the top surface of the plug structure 224 is exposed in the second opening 225.

The formation of the first opening 2134 and the second opening 225 may include the steps of: forming a second patterned photoresist layer 264 on the third buffer dielectric layer 253 (as shown in Fig. 8l); and, with the second patterned photoresist layer 264 serving as a mask, etching the third buffer dielectric layer 253, the first buffer dielectric layer 251, the second isolating oxide layer 2123, the high-k dielectric layer 2122 and the first isolating oxide layer 2121 in the pixel region 21, as well as the third buffer dielectric layer 253 in the pad region 22, thereby forming the first opening 2134 in the buffer dielectric layer in the pixel region 21 and the second opening 225 in the buffer dielectric layer in the pad region 22. As shown in Fig. 8m, in the first opening 2134, part of the substrate 20 around a top side wall portion of the trench fill structure 212, the entire top surface of the trench fill structure 212 and a top side wall portion of the first conductive metal layer 2124 are exposed. In the second opening 225, part of the top surface of the third conductive metal layer 2242 in the plug structure 224 is exposed.

Referring to Figs. 8n to 8p, in step S26, a metal grid layer 2144 is formed on the third buffer dielectric layer 253 in the pixel region 21, and a pad structure 226 on the third buffer dielectric layer 253 in the pad region 22. The metal grid layer 2144 fills up the first opening 2134 and is electrically connected to the exposed part of the substrate 20 and the trench fill structure 212. The pad structure 226 fills up the second opening 225 and is electrically connected to the exposed top portion of the plug structure 224.

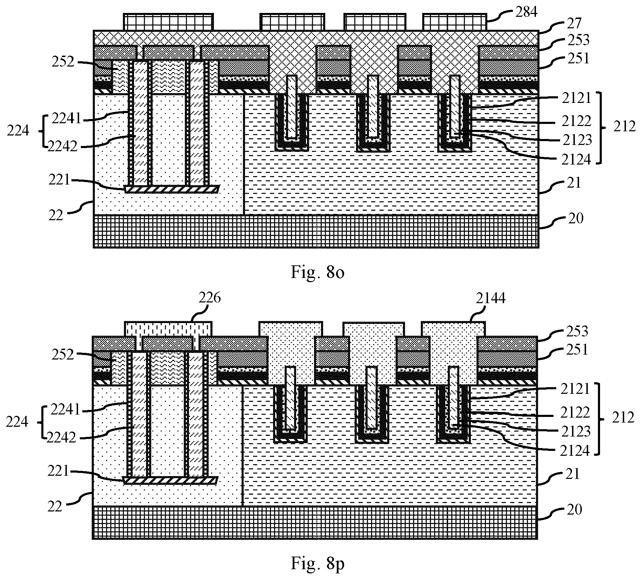

The formation of the metal grid layer 2144 on the third buffer dielectric layer 253 in the pixel region 21 and the pad structure 226 on the third buffer dielectric layer 253 in the pad region 22 may involve the steps of: first of all, as shown in Fig. 8n, forming a second conductive metal layer 27, which covers the third buffer dielectric layer 253 and fills the first opening 2134 and the second opening 225; and then forming a third patterned photoresist layer 284 on the second conductive metal layer 27 (as shown in Fig. 8o) and, with the third patterned photoresist layer 284 serving as a mask, etching the second conductive metal layer 27, thus forming the metal grid layer 2144 in the pixel region 21 and the pad structure 226 in the pad region 22 (as shown in Fig. 8p). The metal grid layer 2144 is electrically connected to the part of the substrate 20 around the top side wall portion of the trench fill structure 212 and the entire top surface of the trench fill structure 212, both exposed in the first opening 2134, and the pad structure 226 is electrically connected to the exposed part of the top surface of the third conductive metal layer 2242 in the plug structure 224.

Further, in the above method, the individual steps are not limited to being performed in the above-described sequential order, and the order may be adapted as appropriate.

In summary, the semiconductor device fabrication method provided in the present invention includes: providing a substrate with a pixel region; forming a trench in the pixel region of the substrate and filling the trench with a fill material, thus forming a trench fill structure, wherein a high-k dielectric layer is sandwiched between a side wall of the fill material and the substrate; covering a surface of the substrate in the pixel region with a buffer dielectric layer so that the trench fill structure is embedded in the buffer dielectric layer; etching the buffer dielectric layer to form a first opening exposing at least part of the substrate around a top side wall portion of the trench fill structure and/or at least a top portion of the trench fill structure; and forming a metal grid layer on the buffer dielectric layer so that the metal grid layer fills the first opening and is electrically connected to the exposed part of the substrate and/or the exposed portion of the trench fill structure. In this method, electrically connecting the metal grid layer to the exposed part of the substrate and/or the exposed portion of the trench fill structure optimizes and improves electrical performance of the semiconductor device.

In an embodiment of the present invention, there is also provided a semiconductor device including a substrate, a trench fill structure, a buffer dielectric layer and a metal grid layer. The substrate has a pixel region. The trench fill structure is formed in the pixel region of the substrate and includes a fill material filled in a trench in the substrate and a high-k dielectric layer sandwiched between a side wall of the fill material and the substrate. The buffer dielectric layer is formed over a surface of the substrate in the pixel region and has a first opening exposing at least part of the substrate around a top side wall portion of the trench fill structure and/or at least a top portion of the trench fill structure. The metal grid layer is formed on the buffer dielectric layer such as to fill the first opening and be electrically connected to the exposed part of the substrate and/or the exposed portion of the trench fill structure.

The semiconductor device provided in the present embodiment will be described in greater detail below with reference to Figs. 3i, 4e, 5e, 6g, 7 and 8p.

The substrate 20 with the pixel region 21 may be any suitable material well known to those skilled in the art. For more details in this regard, reference can be made to the description of step S11, and a further description thereof is omitted here.

The trench fill structure 212 is formed in the pixel region 21 of the substrate 20 and includes the fill material filled in the trench 211 in the substrate 20 and the high-k dielectric layer 2122 sandwiched between the side wall of the fill material and the substrate 20. The trench 211 may be a deep trench with a depth of 1-5 µm. It is to be noted that the depth of the trench 211 is not limited to being within the above range and may be appropriately determined according to performance requirements for the semiconductor device. The trench fill structure 212 may serve to isolate components in the pixel region 21 of the substrate 20. The high-k dielectric layer 2122 is preferred to have a k (dielectric permittivity) value of greater than 7. Materials from which the high-k dielectric layer 2122 can be made may include, but are not limited to, nitrides and metal oxides such as silicon nitride, silicon oxynitride, titanium dioxide, tantalum pentoxide, etc. The high-k dielectric layer 2122 operates at a voltage in a different band and has different charge properties and can thus change the charge in the substrate 20 and reduce a dark current that may produce noise harmful to the performance of the semiconductor device.

The trench fill structure 212 may include a first isolating oxide layer 2121, the high-k dielectric layer 2122 and a second isolating oxide layer 2123, which are sequentially stacked over a surface of the trench 211 in the substrate 20, and the fill material filled in the trench 211. The first isolating oxide layer 2121, the high-k dielectric layer 2122 and the second isolating oxide layer 2123 are arranged at least between the side wall of the fill material and the substrate 20. That is, the first isolating oxide layer 2121, the high-k dielectric layer 2122 and the second isolating oxide layer 2123 in the trench 211 may reside either on only a side wall of the trench 211 or on both the side wall and a bottom wall of the trench 211.

The fill material may include a dielectric material, or a metallic material, or both. When the fill material is a metallic material, as shown in Fig. 3i, the trench fill structure 212 includes the first isolating oxide layer 2121, the high-k dielectric layer 2122 and the second isolating oxide layer 2123, all formed over the surface of the trench 211, and a first conductive metal layer 2124 that fills up the trench 211 (i.e., the fill material provides the first conductive metal layer 2124). The dielectric material may include at least one of silica, silicon nitride, ethyl silicate, borosilicate glass, phosphosilicate glass, boro-phospho-silicate glass and silicon oxynitride, and the metallic material may include at least one of tungsten, nickel, aluminum, silver, gold and titanium.

Additionally, a top surface of the trench fill structure 212 may be flush with the top surface of the substrate 20. Alternatively, the top surface of the trench fill structure 212 may be higher than the top surface of the substrate 20. Alternatively, only a top surface of the fill material in the trench fill structure 212 may be higher than the top surface of the substrate 20.

The buffer dielectric layer is formed on the surface of the substrate 20 in the pixel region 21. The buffer dielectric layer has the first opening 214 exposing at least part of the substrate 20 around a top side wall portion of the trench fill structure 212, at least a top portion of the trench fill structure 212, or both.

The exposure of at least part of the substrate 20 around a top side wall portion of the trench fill structure 212 in the first opening 214 means that the first opening 214 is so formed as to at least surround the top of the trench fill structure 212 so that at least part of the substrate 20 around the top of the trench fill structure 212 is exposed.

The exposure of at least a top portion of the trench fill structure 212 in the first opening 214 may include: when the top surface of the trench fill structure 212 is raised over the top surface of the substrate 20, and if the first opening 214 surrounds only the top side wall portion of the trench fill structure 212 so that the first isolating oxide layer 2121 is exposed at the top side wall portion of the trench fill structure 212, exposure of also part of the substrate 20 around the top side wall portion of the trench fill structure 212 in the first opening 214; when only the top surface of the fill material in the trench fill structure 212 is raised over the top surface of the substrate 20, and if the first opening 214 surrounds only the top side wall portion of the trench fill structure 212, exposure of the fill material in the trench fill structure 212 at the top side wall portion; when the top surface of the trench fill structure 212 is raised over or flush with the top surface of the substrate 20, and if the first opening 214 resides on the top surface of the trench fill structure 212, exposure of part or the entirety of the top surface of the trench fill structure 212, including exposure of part or the entirety of the top surface of the fill material, or exposure of both part or the entirety of the top surface of the fill material and part or the entirety of top surface(s) of the first isolating oxide layer 2121 and/or the high-k dielectric layer 2122 and/or the second isolating oxide layer 2123; and when the top surface of the trench fill structure 212 is raised over the top surface of the substrate 20, exposure of both the first isolating oxide layer 2121, the high-k dielectric layer 2122, the second isolating oxide layer 2123 or the fill material in the trench fill structure 212 at the top side wall portion and part or the entirety of the top surface of the trench fill structure 212.

When the fill material includes the first conductive metal layer 2124, the exposure of at least a top portion of the trench fill structure 212 in the first opening 214 may include: exposure of the first conductive metal layer 2124 at the top side wall portion of the trench fill structure 212 in the first opening 214 that is so formed as to surround the top side wall portion of the trench fill structure 212; or exposure of part or the entirety of the top surface of the first conductive metal layer 2124 in the trench fill structure 212 in the first opening 214 that resides on the top surface of the trench fill structure 212; or exposure of both the first conductive metal layer 2124 in the trench fill structure 212 at the top side wall portion and part or the entirety of the top surface of the first conductive metal layer 2124 in the trench fill structure 212 in the first opening 214.

The metal grid layer is formed on the buffer dielectric layer so as to fill the first opening 214 and be electrically connected to the exposed part of the substrate 20, the exposed portion of the trench fill structure 212, or both.

Electrically connecting the metal grid layer to the exposed part of the substrate 20 and/or the exposed portion of the trench fill structure 212 can optimize and improve electrical performance, such as dark current performance, of the semiconductor device. Moreover, the high-k dielectric layer 2122 in the trench fill structure 212 can additionally reduce the dark current in the semiconductor device, resulting in further optimization and improvement of the semiconductor device's electrical performance.

When only part of the substrate 20 is exposed in the first opening 214, the metal grid layer is electrically connected to only the exposed part of the substrate 20. When at least a top portion of the trench fill structure 212 is exposed in the first opening 214, in consistence with the above enumerated scenarios, the electrical connection of the metal grid layer with the underlying structure includes: when the top surface of the trench fill structure 212 is raised over the top surface of the substrate 20, and if the first opening 214 surrounds only a top side wall portion of the trench fill structure 212 (i.e., the first isolating oxide layer 2121 is exposed at the top side wall portion), electrical connection of the metal grid layer also with only the exposed part of the substrate 20; when only the top surface of the fill material in the trench fill structure 212 is raised over the top surface of the substrate 20 and the first opening 214 surrounds only a top side wall portion of the trench fill structure 212, and if the fill material is the first conductive metal layer 2124, electrical connection of the metal grid layer with the first conductive metal layer 2124 at the top side wall portion of the trench fill structure 212; when the top surface of the trench fill structure 212 is raised over or flush with the top surface of the substrate 20 and the first opening 214 resides on the top surface of the fill material in the trench fill structure 212, and if the fill material is the first conductive metal layer 2124, electrical connection of the metal grid layer with the partially or entirely exposed top surface of the first conductive metal layer 2124 in the trench fill structure 212; when the top surface of the trench fill structure 212 is raised over the top surface of the substrate 20, and if the first opening 214 exposes both the isolating oxide layer 2121 or the first conductive metal layer 2124 at a top side wall portion of the trench fill structure 212 and part or the entirety of the top surface of the first conductive metal layer 2124, electrical connection of the metal grid layer with both the part of the substrate 20 and the first conductive metal layer 2124.

Exemplary scenarios of the electrical connection of the metal grid layer with the exposed part of the substrate 20 and/or the exposed portion of the trench fill structure 212 may include: as shown in Fig. 3i, electrical connection of the metal grid layer 2151 with part of the substrate 20 around a top side wall portion of the trench fill structure 212 and the entire top surface of the trench fill structure 212, both exposed in the first opening 214; as shown in Fig. 4e, electrical connection of the metal grid layer 2142 with part of the top surface of the first conductive metal layer 2124 in the trench fill structure 212 exposed in the first opening 2132; as shown in Fig. 5e, electrical connection of the metal grid layer 2143 with part of the substrate 20 around a top side wall portion of the trench fill structure 212 exposed in the first opening 214; as shown in Fig. 6g, electrical connection of the metal grid layer 2144 with part of the substrate 20 around a top side wall portion of the trench fill structure 212 and the entire top surface of the trench fill structure 212, both exposed in the first opening 214, with contact of the metal grid layer 2144 with a top side wall portion of the first conductive metal layer 2124; as shown in Fig. 7, electrical connection of the metal grid layer 2145 with part of the substrate 20 around a top side wall portion of the trench fill structure 212 and part of the top surface of the first conductive metal layer 2124 in the trench fill structure 212, both exposed in the first opening 214.

The substrate further includes a pad region peripheral to the pixel region. A metal interconnection is formed in the substrate in the pad region, and a plug structure above the metal interconnection. The plug structure is electrically connected at the bottom to the metal interconnection and at the top to a pad structure. It is to be noted that another metal structure than the metal interconnection may be formed in the pad region of the substrate so as to be electrically connected to the bottom of the plug structure. For example, the metal structure may be a conductive contact plug electrically connected to the bottom of the plug structure. These metal structures are exemplified below by the metal interconnection.

The plug structure includes: a third isolating oxide layer on a side wall of a through hole in which part of a top surface of the metal interconnection is exposed; and a third conductive metal layer which fills up the through hole. The buffer dielectric layer is so formed as to also cover the surface of the substrate in the pad region and have a second opening in which part of a top surface of the plug structure is exposed. The pad structure is formed on the buffer dielectric layer in the pad region so as to fill up the second opening and be electrically connected to the top of the plug structure.

If the high-k dielectric layer is formed in the plug structure in the pad region, the device will have increased capacitance, which will lead to a significant transmission delay (RC delay) and degradation in the performance of the semiconductor device. Therefore, the high-k dielectric layer shall not be formed in the plug structure in the pad region.

The various scenarios of the electrical connection of the metal grid layer in the pixel region to the exposed part of the substrate and/or the exposed portion of the trench fill structure have been described above and, therefore, need not be described in further detail herein. Below, the trench fill structure 212 and the metal grid layer 2144 in the pixel region 21 and the plug structure 224 and the pad structure 226 in the pad region 22 will be described, with the scenario shown in Fig. 8p where the metal grid layer 2144 is electrically connected to part of the substrate 20 around a top side wall portion of the trench fill structure 212 and the entire top surface of the trench fill structure 212, both exposed in the first opening 2134 as an example.

The plug structure 224 includes: the third isolating oxide layer 2241 on the side wall of the through hole 223 in which part of the top surface of the metal interconnection 221 is exposed; and the third conductive metal layer 2242 which fills up the through hole 223. The third conductive metal layer 2242 in the plug structure 224 is electrically connected at the bottom to the metal interconnection 221.

The first isolating oxide layer 2121, the high-k dielectric layer 2122, the second isolating oxide layer 2123, the first buffer dielectric layer 251, the second buffer dielectric layer 252 and the third buffer dielectric layer 253, which are laminated over the substrate 20 so as to bury the trench fill structure 212 and the plug structure 224, make up the aforementioned buffer dielectric layer 25.

The first opening 2134 is formed in the buffer dielectric layer 25 in the pixel region 21 (i.e., in the first isolating oxide layer 2121, the high-k dielectric layer 2122, the second isolating oxide layer 2123, the first buffer dielectric layer 251 and the third buffer dielectric layer 253 over the substrate 20), and the second opening 225 is formed in the buffer dielectric layer 25 in the pad region 22 (i.e., in the third buffer dielectric layer 253). The first opening 2134 exposes part of the substrate 20 around a top side wall portion of the trench fill structure 212, the entire top surface of the trench fill structure 212, and a top side wall portion of the first conductive metal layer 2124. The second opening 225 exposes part of the top surface of the third conductive metal layer 2242 in the plug structure 224.

The metal grid layer 2144 is formed on the buffer dielectric layer 25 in the pixel region 21 (i.e., on the third buffer dielectric layer 253), and the pad structure 226 is formed on the buffer dielectric layer 25 in the pad region 22. The metal grid layer 2144 fills up the first opening 2134 and is electrically connected to the exposed part of the substrate 20 and the trench fill structure 212. The pad structure 226 fills up the second opening 225 and is electrically connected to the exposed top portion of the plug structure 224.

In summary, the semiconductor device provided in the present invention includes: a substrate with a pixel region; a trench fill structure formed in the pixel region of the substrate, the trench fill structure including a fill material filled in a trench in the substrate and a high-k dielectric layer sandwiched between a side wall of the fill material and the substrate; a buffer dielectric layer formed on the surface of the substrate in the pixel region, the buffer dielectric layer having a first opening exposing at least part of the substrate around a top side wall portion of the trench fill structure and/or at least a top portion of the trench fill structure; and a metal grid layer formed on the buffer dielectric layer, the metal grid layer filling the first opening and being electrically connected to the exposed part of the substrate and/or the exposed portion of the trench fill structure. In the semiconductor device of the present invention, the metal grid layer is electrically connected to the exposed part of the substrate and/or the exposed portion of the trench fill structure, resulting in optimized and improved electrical performance of the semiconductor device.

The description presented above is merely that of a few preferred embodiments of the present invention and is not intended to limit the scope thereof in any sense. Any and all changes and modifications made by those of ordinary skill in the art based on the above teachings fall within the scope as defined in the appended claims.

## Claims

1. A method of manufacturing a semiconductor device, comprising:
providing a substrate (20) with a pixel region (21);
forming a trench fill structure (212) in the pixel region (21) of the substrate (20);
covering the surface of the substrate (20) in the pixel region (21) with a buffer dielectric layer (25) so that the trench fill structure is embedded in the buffer dielectric layer (25);
etching the buffer dielectric layer (25) to form a first opening (2131, 2132, 2133, 2134) exposing at least part of the substrate (20) around a top side wall portion of the trench fill structure, or exposing both of at least part of the substrate (20) around a top side wall portion of the trench fill structure (212) and at least a top portion of the trench fill structure; and
forming a metal grid layer (2141, 2142, 2143, 2144, 2145) on the buffer dielectric layer (25) so that the metal grid layer (2141, 2142, 2143, 2144, 2145) fills the first opening (2131, 2132, 2133, 2134) and is electrically connected to the exposed part of the substrate (20), or the metal grid layer (2141, 2142, 2143, 2144, 2145) being electrically connected to both of the exposed part of the substrate (20) and the exposed portion of the trench fill structure.

2. The method of manufacturing a semiconductor device of claim **1,** wherein the step of forming the trench fill structure (212) in the pixel region (21) of the substrate (20) comprises:
covering the surface of the substrate (20) in the pixel region (21) with a pad oxide layer (23);
forming a first patterned photoresist layer (24) on the pad oxide layer (23) and, with the first patterned photoresist layer (24) serving as a mask, etching through the pad oxide layer (23) and at least a partial thickness of the substrate (20), thereby forming the trench in the pixel region (21) of the substrate (20);
removing the first patterned photoresist layer (24) and the pad oxide layer (23);
successively forming a first isolating oxide layer (2121), a high-k dielectric layer (2122) and a second isolating oxide layer (2123) both in the trench and on the surface of the substrate (20);
filling the fill material in the trench in such a manner that the fill material also covers the second isolating oxide layer (2123) outside the trench; and
performing an etching or chemical mechanical polishing process to remove the fill material, the second isolating oxide layer (2123), the high-k dielectric layer (2122) and the first isolating oxide layer (2121) above the surface of the substrate (20) outside the trench, or to remove only the fill material above the surface of the substrate (20) outside the trench, thereby forming the trench fill structure (212) in the trench.

3. The method of manufacturing a semiconductor device of claim 1, wherein the trench fill structure comprises a first conductive metal layer (2124), and wherein the exposure of at least a top portion of the trench fill structure (212) in the first opening (2131, 2132, 2133, 2134) comprises: exposure of the first conductive metal layer (2124) at a top side wall portion of the trench fill structure in the first opening (2131, 2132, 2133, 2134) that is so formed as to surround the top side wall portion of the trench fill structure; and/or exposure of part or the entirety of a top surface of the first conductive metal layer (2124) in the trench fill structure in the first opening (2131, 2132, 2133, 2134) that resides on a top surface of the trench fill structure (212).

4. The method of manufacturing a semiconductor device of claim 1, wherein the step of forming the first opening (2131, 2132, 2133, 2134) by etching the buffer dielectric layer (25) comprises:
forming a second patterned photoresist layer (261, 262, 263, 264) on the buffer dielectric layer (25) and, with the second patterned photoresist layer (261, 262, 263, 264) serving as a mask, etching the buffer dielectric layer (25), thereby forming the first opening (2131, 2132, 2133, 2134) in the buffer dielectric layer (25) in the pixel region (21), the first opening (2131, 2132, 2133, 2134) exposing at least part of the substrate (20) around a top side wall portion of the trench fill structure (212) and/or at least a top portion of the trench fill structure (212); and
removing the second patterned photoresist layer (261, 262, 263, 264).

5. The method of manufacturing a semiconductor device of claim 1, wherein the step of forming the metal grid layer (2141, 2142, 2143, 2144, 2145) on the buffer dielectric layer (25) comprises:
forming a second conductive metal layer (27), which covers the buffer dielectric layer (25) and fills up the first opening (2131, 2132, 2133, 2134);
forming a third patterned photoresist layer (281, 282, 283, 284) on the second conductive metal layer (27) and, with the third patterned photoresist layer (281, 282, 283, 284) serving as a mask, etching the second conductive metal layer (27), thus forming the metal grid layer (2141, 2142, 2143, 2144, 2145) in the pixel region (21), the metal grid layer (2141, 2142, 2143, 2144, 2145) is electrically connected to the part of the substrate (20) and/or the portion of the trench fill structure (212) exposed in the first opening (2131, 2132, 2133, 2134); and
removing the third patterned photoresist layer (281, 282, 283, 284).

6. The method of manufacturing a semiconductor device of any one of claims 1 to 5, wherein the substrate (20) further has a pad region (22) peripheral to the pixel region (21), and wherein a metal interconnection (221) is formed in the pad region (22) of the substrate (20) and a plug structure (224) above the metal interconnection (221), the bottom of the plug structure (224) being electrically connected to the metal interconnection (221).

7. The method of manufacturing a semiconductor device of claim 6, wherein the plug structure (224) is formed in the pad region (22) of the substrate (20) subsequent to the formation of the trench fill structure (212) and prior to the covering of the surface (20) of the substrate (20) in the pixel region (21) with the buffer dielectric layer (25).

8. The method of manufacturing a semiconductor device of claim 6, wherein in the step of covering the surface (20) of the substrate in the pixel region (21) with the buffer dielectric layer (25), the buffer dielectric layer (25) is so formed as to further cover the surface of the substrate (20) in the pad region (22) so that the plug structure (224) is embedded in the buffer dielectric layer (25), wherein at the same time when the first opening (2131, 2132, 2133, 2134) is formed by etching the buffer dielectric layer (25) in the pixel region (21), the buffer dielectric layer (25) in the pad region (22) is also etched to form a second opening (225) exposing part of a top surface of the plug structure (224), and wherein at the same time when the metal grid layer (2141, 2142, 2143, 2144, 2145) is formed on the buffer dielectric layer (25) in the pixel region (21), a pad structure (226) is formed on the buffer dielectric layer (25) in the pad region (22) so as to fill up the second opening (225) and be electrically connected to the exposed top part of the plug structure (224).

9. A semiconductor device, comprising:
a substrate (20) with a pixel region (21), the substrate comprising a trench formed in the pixel region (21);
a trench fill structure (212) formed in the pixel region (21) of the substrate (20);
a buffer dielectric layer (25) covering the surface of the substrate (20) in the pixel region (21), the buffer dielectric layer (25) comprising a first opening (2131, 2132, 2133, 2134) exposing at least part of the substrate (20) around a top side wall portion of the trench fill structure (212), or exposing both of at least part of the substrate (20) around a top side wall portion of the trench fill structure (212) and at least a top portion of the trench fill structure (212); and
a metal grid layer (2141, 2142, 2143, 2144, 2145) formed on the buffer dielectric layer (25) so as to fill the first opening (2131, 2132, 2133, 2134) and be electrically connected to the exposed part of the substrate (20), or the metal grid layer (2141, 2142, 2143, 2144, 2145) being electrically connected to both of the exposed part of the substrate (20) and the exposed portion of the trench fill structure.

10. The semiconductor device of claim 9, wherein the trench fill structure (212) comprises a first isolating oxide layer (2121), a high-k dielectric layer (2122), a second isolating oxide layer (2123), which are sequentially stacked over a surface of the trench in the substrate (20), and the fill material filled in the trench, the first isolating oxide layer (2121), the high-k dielectric layer (2122) and the second isolating oxide layer (2123) being situated at least between the side wall of the fill material and the substrate (20).

11. The semiconductor device of claim 9, wherein the trench fill structure comprises a first conductive metal layer (2124), and wherein the exposure of at least a top portion of the trench fill structure (212) in the first opening (2131, 2132, 2133, 2134) comprises: exposure of the first conductive metal layer (2124) at a top side wall portion of the trench fill structure (212) in the first opening (2131, 2132, 2133, 2134) that is so formed as to surround the top side wall portion of the trench fill structure (212); and/or exposure of part or the entirety of a top surface of the first conductive metal layer (2124) in the trench fill structure (212) in the first opening (2131, 2132, 2133, 2134) that resides on a top surface of the trench fill structure (212).

12. The semiconductor device of claim 9, wherein the trench fill structure (212) comprises a high-k dielectric layer (2122), the high-k dielectric layer (2122) being sandwiched between a side wall of a fill material and the substrate (20), and wherein the high-k dielectric layer (2122) has a k value of greater than 7.

13. The semiconductor device of any one of claims 9 to 12, wherein the substrate (20) further has a pad region (22) peripheral to the pixel region (21), and wherein a metal interconnection (221) is formed in the pad region (22) of the substrate (20) and a plug structure (224) above the metal interconnection (221), the bottom of the plug structure (224) being electrically connected to the metal interconnection (221).

14. The semiconductor device of claim 13, wherein a through hole (223) is formed in the pad region (22) of the substrate (20), the through hole (223) exposing at least part of a top surface of the metal interconnection (221), and wherein the plug structure (224) comprises a third isolating oxide layer (2241) on a side wall of the through hole (223) and a third conductive metal layer (2242) which fills up the through hole (223).

15. The semiconductor device of claim 13, wherein the buffer dielectric layer (25) further covers the surface of the substrate (20) in the pad region (22) and comprises a second opening (225) exposing at least a top portion of the plug structure (224), and wherein a pad structure (226) is formed on the buffer dielectric layer (25) in the pad region (22) so as to fill up the second opening (225) and be electrically connected to the exposed top portion of the plug structure (224).

## Patentansprüche

1. Ein Verfahren zur Herstellung eines Halbleiterbauelements, umfassend:
Bereitstellen eines Substrats (20) mit einem Pixelbereich (21);
Bilden einer Grabenfüllstruktur (212) in dem Pixelbereich (21) des Substrats (20);
Bedecken der Oberfläche des Substrats (20) in dem Pixelbereich (21) mit einer dielektrischen Pufferschicht (25), so dass die Grabenfüllstruktur in die dielektrische Pufferschicht eingebettet ist (25);
Ätzen der dielektrischen Pufferschicht (25), um eine erste Öffnung (2131, 2132, 2133, 2134) zu bilden, wobei mindestens ein Teil des Substrats (20) um einen oberen Seitenwandabschnitt der Grabenfüllstruktur freigelegt wird, oder wobei sowohl mindestens ein Teil des Substrats (20) um einen oberen Seitenwandabschnitt der Grabenfüllstruktur (212) als auch mindestens ein oberer Teil der Grabenfüllstruktur freigelegt wird; und
Bilden einer Metallgitterschicht (2141, 2142, 2143, 2144, 2145) auf der dielektrischen Pufferschicht (25), so dass die Metallgitterschicht (2141, 2142, 2143, 2144, 2145) die erste Öffnung (2131, 2132, 2133, 2134) füllt und elektrisch mit dem freigelegten Teil des Substrats (20) verbunden ist, oder wobei die Metallgitterschicht (2141, 2142, 2143, 2144, 2145) elektrisch sowohl mit dem freigelegten Teil des Substrats (20) als auch mit dem freigelegten Teil der Grabenfüllstruktur verbunden ist.

2. Das Verfahren zur Herstellung eines Halbleiterbauelements nach Anspruch 1, wobei der Schritt des Bildens der Grabenfüllstruktur (212) in dem Pixelbereich (21) des Substrats (20) umfasst:
Bedecken der Oberfläche des Substrats (20) in dem Pixelbereich (21) mit einer Pad-Oxidschicht (23);
Bilden einer ersten strukturierten Fotolackschicht (24) auf der Pad-Oxidschicht (23) und, wobei die erste strukturierte Fotolackschicht (24) als Maske dient, Ätzen durch die Pad-Oxidschicht (23) und mindestens eine Teildicke des Substrats (20), wodurch der Graben in dem Pixelbereich (21) des Substrats (20) gebildet wird;
Entfernen der ersten strukturierten Fotolackschicht (24) und der Pad-Oxidschicht (23);
sukzessives Bilden einer ersten isolierenden Oxidschicht (2121), einer dielektrischen Schicht mit hoher Dielektrizitätskonstante (2122) und einer zweiten isolierenden Oxidschicht (2123) sowohl in dem Graben als auch auf der Oberfläche des Substrats (20);
Einfüllen des Füllmaterials in den Graben in einer Weise, dass das Füllmaterial auch die zweite isolierende Oxidschicht (2123) außerhalb des Grabens bedeckt; und
Durchführen eines Ätz- oder chemisch-mechanischen Polierprozesses, um das Füllmaterial, die zweite isolierende Oxidschicht (2123), die dielektrische Schicht mit hoher Dielektrizitätskonstante (2122) und die erste isolierende Oxidschicht (2121) oberhalb der Oberfläche des Substrats (20) außerhalb des Grabens zu entfernen, oder um nur das Füllmaterial oberhalb der Oberfläche des Substrats (20) außerhalb des Grabens zu entfernen, wodurch die Grabenfüllstruktur (212) in dem Graben gebildet wird.

3. Das Verfahren zur Herstellung eines Halbleiterbauelements nach Anspruch 1, wobei die Grabenfüllstruktur eine erste leitfähige Metallschicht (2124) umfasst, und wobei das Freilegen mindestens eines oberen Teils der Grabenfüllstruktur (212) in der ersten Öffnung (2131, 2132, 2133, 2134) umfasst: Freilegen der ersten leitfähigen Metallschicht (2124) an einem oberen Seitenwandabschnitt der Grabenfüllstruktur in der ersten Öffnung (2131, 2132, 2133, 2134), die so ausgebildet ist, dass sie den oberen Seitenwandabschnitt der Grabenfüllstruktur umschließt; und/oder Freilegen eines Teils oder der gesamten Oberseite der ersten leitfähigen Metallschicht (2124) in der Grabenfüllstruktur in der ersten Öffnung (2131, 2132, 2133, 2134), die sich auf einer Oberseite der Grabenfüllstruktur (212) befindet.

4. Das Verfahren zur Herstellung eines Halbleiterbauelements nach Anspruch 1, wobei der Schritt des Bildens der ersten Öffnung (2131, 2132, 2133, 2134) durch Ätzen der dielektrischen Pufferschicht (25) umfasst:
Bilden einer zweiten strukturierten Fotolackschicht (261, 262, 263, 264) auf der dielektrischen Pufferschicht (25) und, wobei die zweite strukturierte Fotolackschicht (261, 262, 263, 264) als Maske dient, Ätzen der dielektrischen Pufferschicht (25), wodurch die erste Öffnung (2131, 2132, 2133, 2134) in der dielektrischen Pufferschicht (25) in dem Pixelbereich (21) gebildet wird, wobei die erste Öffnung (2131, 2132, 2133, 2134) mindestens einen Teil des Substrats (20) um einen oberen Seitenwandabschnitt der Grabenfüllstruktur (212) und/oder mindestens einen oberen Teil der Grabenfüllstruktur (212) freilegt; und
Entfernen der zweiten strukturierten Fotolackschicht (261, 262, 263, 264).

5. Das Verfahren zur Herstellung eines Halbleiterbauelements nach Anspruch 1, wobei der Schritt des Bildens der Metallgitterschicht (2141, 2142, 2143, 2144, 2145) auf der dielektrischen Pufferschicht (25) umfasst:
Bilden einer zweiten leitfähigen Metallschicht (27), die die dielektrische Pufferschicht (25) bedeckt und die erste Öffnung (2131, 2132, 2133, 2134) ausfüllt;
Bilden einer dritten strukturierten Fotolackschicht (281, 282, 283, 284) auf der zweiten leitfähigen Metallschicht (27) und, wobei die dritte strukturierte Fotolackschicht (281, 282, 283, 284) als Maske dient, Ätzen der zweiten leitfähigen Metallschicht (27), wodurch die Metallgitterschicht (2141, 2142, 2143, 2144, 2145) in dem Pixelbereich (21) gebildet wird, wobei die Metallgitterschicht (2141, 2142, 2143, 2144, 2145) elektrisch mit dem Teil des Substrats (20) und/oder dem Teil der Grabenfüllstruktur (212) verbunden ist, die in der ersten Öffnung (2131, 2132, 2133, 2134) freigelegt sind; und
Entfernen der dritten strukturierten Fotolackschicht (281, 282, 283, 284).

6. Das Verfahren zur Herstellung eines Halbleiterbauelements nach einem der Ansprüche 1 bis 5, wobei das Substrat (20) ferner einen Pad-Bereich (22) peripher zum Pixelbereich (21) aufweist, und wobei eine Metallverbindung (221) in dem Pad-Bereich (22) des Substrats (20) und eine Steckerstruktur (224) oberhalb der Metallverbindung (221) gebildet werden, wobei der Boden der Steckerstruktur (224) elektrisch mit der Metallverbindung (221) verbunden ist.

7. Das Verfahren zur Herstellung eines Halbleiterbauelements nach Anspruch 6, wobei die Steckerstruktur (224) in dem Pad-Bereich (22) des Substrats (20) im Anschluss an die Bildung der Grabenfüllstruktur (212) und vor dem Bedecken der Oberfläche (20) des Substrats (20) in dem Pixelbereich (21) mit der dielektrischen Pufferschicht (25) gebildet wird.

8. Das Verfahren zur Herstellung eines Halbleiterbauelements nach Anspruch 6, wobei in dem Schritt des Bedeckens der Oberfläche (20) des Substrats in dem Pixelbereich (21) mit der dielektrischen Pufferschicht (25), die dielektrische Pufferschicht (25) so ausgebildet ist, dass sie ferner die Oberfläche des Substrats (20) in dem Pad-Bereich (22) bedeckt, sodass die Steckerstruktur (224) in die dielektrische Pufferschicht (25) eingebettet ist, wobei gleichzeitig, wenn die erste Öffnung (2131, 2132, 2133, 2134) durch Ätzen der dielektrischen Pufferschicht (25) in dem Pixelbereich (21) gebildet wird, die dielektrische Pufferschicht (25) in dem Pad-Bereich (22) ebenfalls geätzt wird, um eine zweite Öffnung (225) zu bilden, die einen Teil einer Oberseite der Steckerstruktur (224) freilegt, und wobei gleichzeitig, wenn die Metallgitterschicht (2141, 2142, 2143, 2144, 2145) auf der dielektrischen Pufferschicht (25) in dem Pixelbereich (21) gebildet wird, eine Pad-Struktur (226) auf der dielektrischen Pufferschicht (25) in dem Pad-Bereich (22) gebildet wird, um die zweite Öffnung (225) auszufüllen und elektrisch mit dem freigelegten oberen Teil der Steckerstruktur (224) verbunden zu sein.

9. Ein Halbleiterbauelement, umfassend:
ein Substrat (20) mit einem Pixelbereich (21), wobei das Substrat einen in dem Pixelbereich ausgebildeten Graben aufweist (21);
eine Grabenfüllstruktur (212), die in dem Pixelbereich (21) des Substrats (20) ausgebildet ist;
eine dielektrische Pufferschicht (25), welche die Oberfläche des Substrats (20) in dem Pixelbereich (21) bedeckt, wobei die dielektrische Pufferschicht (25) eine erste Öffnung (2131, 2132, 2133, 2134) aufweist, die mindestens einen Teil des Substrats (20) um einen oberen Seitenwandabschnitt der Grabenfüllstruktur (212) freilegt, oder die sowohl mindestens einen Teil des Substrats (20) um einen oberen Seitenwandabschnitt der Grabenfüllstruktur (212) als auch mindestens einen oberen Teil der Grabenfüllstruktur (212) freilegt; und
eine Metallgitterschicht (2141, 2142, 2143, 2144, 2145), die auf der dielektrischen Pufferschicht (25) ausgebildet ist, um die erste Öffnung (2131, 2132, 2133, 2134) auszufüllen und elektrisch mit dem freigelegten Teil des Substrats (20) verbunden zu sein, oder wobei die Metallgitterschicht (2141, 2142, 2143, 2144, 2145) elektrisch sowohl mit dem freigelegten Teil des Substrats (20) als auch mit dem freigelegten Teil der Grabenfüllstruktur verbunden ist.

10. Das Halbleiterbauelement nach Anspruch 9, wobei die Grabenfüllstruktur (212) eine erste isolierende Oxidschicht (2121), eine dielektrische Schicht mit hoher Dielektrizitätskonstante (2122) und eine zweite isolierende Oxidschicht (2123) umfasst, die nacheinander über einer Oberfläche des Grabens in dem Substrat (20) gestapelt sind, und wobei das in den Graben eingefüllte Füllmaterial, die erste isolierende Oxidschicht (2121), die dielektrische Schicht mit hoher Dielektrizitätskonstante (2122) und die zweite isolierende Oxidschicht (2123) mindestens zwischen der Seitenwand des Füllmaterials und dem Substrat (20) angeordnet sind.

11. Das Halbleiterbauelement nach Anspruch 9, wobei die Grabenfüllstruktur eine erste leitfähige Metallschicht (2124) umfasst, und wobei das Freilegen mindestens eines oberen Teils der Grabenfüllstruktur (212) in der ersten Öffnung (2131, 2132, 2133, 2134) umfasst: Freilegen der ersten leitfähigen Metallschicht (2124) an einem oberen Seitenwandabschnitt der Grabenfüllstruktur (212) in der ersten Öffnung (2131, 2132, 2133, 2134), die so ausgebildet ist, dass sie den oberen Seitenwandabschnitt der Grabenfüllstruktur (212) umschließt; und/oder Freilegen eines Teils oder der gesamten Oberseite der ersten leitfähigen Metallschicht (2124) in der Grabenfüllstruktur (212) in der ersten Öffnung (2131, 2132, 2133, 2134), die sich auf einer Oberseite der Grabenfüllstruktur (212) befindet.

12. Das Halbleiterbauelement nach Anspruch 9, wobei die Grabenfüllstruktur (212) eine dielektrische Schicht mit hoher Dielektrizitätskonstante (2122) umfasst, wobei die dielektrische Schicht mit hoher Dielektrizitätskonstante (2122) zwischen einer Seitenwand aus Füllmaterial und dem Substrat (20) angeordnet ist, und wobei die dielektrische Schicht mit hoher Dielektrizitätskonstante (2122) einen k-Wert von mehr als 7 aufweist.

13. Das Halbleiterbauelement nach einem der Ansprüche 9 bis 12, wobei das Substrat (20) ferner einen Pad-Bereich (22) peripher zu dem Pixelbereich (21) aufweist, und wobei eine Metallverbindung (221) in dem Pad-Bereich (22) des Substrats (20) und eine Steckerstruktur (224) oberhalb der Metallverbindung (221) ausgebildet sind, wobei der Boden der Steckerstruktur (224) elektrisch mit der Metallverbindung (221) verbunden ist.

14. Das Halbleiterbauelement nach Anspruch 13, wobei ein Durchgangsloch (223) in dem Pad-Bereich (22) des Substrats (20) ausgebildet ist, wobei das Durchgangsloch (223) mindestens einen Teil einer Oberseite der Metallverbindung (221) freilegt, und wobei die Steckerstruktur (224) eine dritte isolierende Oxidschicht (2241) an einer Seitenwand des Durchgangslochs (223) und eine dritte leitfähige Metallschicht (2242) umfasst, welche das Durchgangsloch (223) ausfüllt.

15. Das Halbleiterbauelement nach Anspruch 13, wobei die dielektrische Pufferschicht (25) ferner die Oberfläche des Substrats (20) in dem Pad-Bereich (22) bedeckt und eine zweite Öffnung (225) aufweist, die mindestens einen oberen Teil der Steckerstruktur (224) freilegt, und wobei eine Pad-Struktur (226) auf der dielektrischen Pufferschicht (25) in dem Pad-Bereich (22) ausgebildet ist, um die zweite Öffnung (225) auszufüllen und elektrisch mit dem freigelegten oberen Teil der Steckerstruktur (224) verbunden zu sein.

## Revendications

1. Procédé de fabrication d'un dispositif semi-conducteur, comprenant :
le fait de fournir un substrat (20) avec une région de pixels (21) ;
le fait de former une structure de remplissage de tranchée (212) dans la région de pixels (21) du substrat (20) ;
le fait de recouvrir la surface du substrat (20) dans la région de pixels (21) avec une couche diélectrique tampon (25) de sorte que la structure de remplissage de tranchée soit intégrée dans la couche diélectrique tampon (25) ;
le fait de graver la couche diélectrique tampon (25) pour former une première ouverture (2131, 2132, 2133, 2134) exposant au moins une partie du substrat (20) autour d'une partie supérieure de paroi latérale de la structure de remplissage de tranchée, ou exposant à la fois au moins une partie du substrat (20) autour d'une partie supérieure de paroi latérale de la structure de remplissage de tranchée (212) et au moins une partie supérieure de la structure de remplissage de tranchée ; et
le fait de former une couche de grille métallique (2141, 2142, 2143, 2144, 2145) sur la couche diélectrique tampon (25) de sorte que la couche de grille métallique (2141, 2142, 2143, 2144, 2145) remplisse la première ouverture (2131, 2132, 2133, 2134) et soit électriquement connectée à la partie exposée du substrat (20), ou que la couche de grille métallique (2141, 2142, 2143, 2144, 2145) soit électriquement connectée à la fois à la partie exposée du substrat (20) et à la partie exposée de la structure de remplissage de tranchée.

2. Procédé de fabrication d'un dispositif semi-conducteur selon la revendication 1, dans lequel l'étape de formation de la structure de remplissage de tranchée (212) dans la région de pixels (21) du substrat (20) comprend :
le fait de recouvrir la surface du substrat (20) dans la région de pixels (21) avec une couche d'oxyde de protection (23) ;
le fait de former une première couche de photorésine structurée (24) sur la couche d'oxyde de protection (23) et, la première couche de photorésine structurée (24) servant de masque, de graver à travers la couche d'oxyde de protection (23) et au moins une partie de l'épaisseur du substrat (20), formant ainsi la tranchée dans la région de pixels (21) du substrat (20) ;
le fait d'éliminer la première couche de photorésine structurée (24) et la couche d'oxyde de protection (23) ;
le fait de former successivement une première couche d'oxyde isolante (2121), une couche diélectrique à constante diélectrique élevée (2122) et une seconde couche d'oxyde isolante (2123) à la fois dans la tranchée et sur la surface du substrat (20) ;
le fait de remplir la tranchée avec le matériau de remplissage de telle sorte que le matériau de remplissage recouvre également la seconde couche d'oxyde isolante (2123) à l'extérieur de la tranchée ; et
le fait d'effectuer un procédé de gravure ou de polissage mécano-chimique pour éliminer le matériau de remplissage, la seconde couche d'oxyde isolante (2123), la couche diélectrique à constante diélectrique élevée (2122) et la première couche d'oxyde isolante (2121) au-dessus de la surface du substrat (20) à l'extérieur de la tranchée, ou pour éliminer uniquement le matériau de remplissage au-dessus de la surface du substrat (20) à l'extérieur de la tranchée, formant ainsi la structure de remplissage de tranchée (212) dans la tranchée.

3. Procédé de fabrication d'un dispositif semi-conducteur selon la revendication 1, dans lequel la structure de remplissage de tranchée comprend une première couche métallique conductrice (2124), et dans lequel l'exposition d'au moins une partie supérieure de la structure de remplissage de tranchée (212) dans la première ouverture (2131, 2132, 2133, 2134) comprend : l'exposition de la première couche métallique conductrice (2124) au niveau d'une partie supérieure de paroi latérale de la structure de remplissage de tranchée dans la première ouverture (2131, 2132, 2133, 2134) qui est configurée pour entourer la partie supérieure de paroi latérale de la structure de remplissage de tranchée ; et/ou l'exposition d'une partie ou de la totalité d'une surface supérieure de la première couche métallique conductrice (2124) dans la structure de remplissage de tranchée dans la première ouverture (2131, 2132, 2133, 2134) qui se trouve sur une surface supérieure de la structure de remplissage de tranchée (212).

4. Procédé de fabrication d'un dispositif semi-conducteur selon la revendication 1, dans lequel l'étape de formation de la première ouverture (2131, 2132, 2133, 2134) par gravure de la couche diélectrique tampon (25) comprend :
le fait de former une seconde couche de photorésine structurée (261, 262, 263, 264) sur la couche diélectrique tampon (25) et, la seconde couche de photorésine structurée (261, 262, 263, 264) servant de masque, de graver la couche diélectrique tampon (25), formant ainsi la première ouverture (2131, 2132, 2133, 2134) dans la couche diélectrique tampon (25) dans la région de pixels (21), la première ouverture (2131, 2132, 2133, 2134) exposant au moins une partie du substrat (20) autour d'une partie supérieure de paroi latérale de la structure de remplissage de tranchée (212) et/ou au moins une partie supérieure de la structure de remplissage de tranchée (212) ; et
le fait d'éliminer la seconde couche de photorésine structurée (261, 262, 263, 264).

5. Procédé de fabrication d'un dispositif semi-conducteur selon la revendication 1, dans lequel l'étape de formation de la couche de grille métallique (2141, 2142, 2143, 2144, 2145) sur la couche diélectrique tampon (25) comprend :
le fait de former une seconde couche métallique conductrice (27) qui recouvre la couche diélectrique tampon (25) et remplit la première ouverture (2131, 2132, 2133, 2134) ;
le fait de former une troisième couche de photorésine structurée (281, 282, 283, 284) sur la seconde couche métallique conductrice (27) et, la troisième couche de photorésine structurée (281, 282, 283, 284) servant de masque, de graver la seconde couche métallique conductrice (27), formant ainsi la couche de grille métallique (2141, 2142, 2143, 2144, 2145) dans la région de pixels (21), la couche de grille métallique (2141, 2142, 2143, 2144, 2145) étant électriquement connectée à la partie du substrat (20) et/ou à la partie de la structure de remplissage de tranchée (212) exposée dans la première ouverture (2131, 2132, 2133, 2134) ; et
le fait d'éliminer la troisième couche de photorésine structurée (281, 282, 283, 284).

6. Procédé de fabrication d'un dispositif semi-conducteur selon l'une quelconque des revendications 1 à 5, dans lequel le substrat (20) comporte en outre une zone de plot (22) périphérique à la région de pixels (21), et dans lequel une interconnexion métallique (221) est formée dans la zone de plot (22) du substrat (20) et une structure de plot (224) est formée au-dessus de l'interconnexion métallique (221), la partie inférieure de la structure de plot (224) étant électriquement connectée à l'interconnexion métallique (221).

7. Procédé de fabrication d'un dispositif semi-conducteur selon la revendication 6, dans lequel la structure de plot (224) est formée dans la zone de plot (22) du substrat (20) après la formation de la structure de remplissage de tranchée (212) et avant le recouvrement de la surface du substrat (20) dans la région de pixels (21) avec la couche diélectrique tampon (25).

8. Procédé de fabrication d'un dispositif semi-conducteur selon la revendication 6, dans lequel, lors de l'étape de recouvrement de la surface du substrat dans la région de pixels (21) avec la couche diélectrique tampon (25), la couche diélectrique tampon (25) est formée de manière à recouvrir également la surface du substrat (20) dans la zone de plot (22) de sorte que la structure de plot (224) soit intégrée dans la couche diélectrique tampon (25), dans lequel, au même moment où la première ouverture (2131, 2132, 2133, 2134) est formée par gravure de la couche diélectrique tampon (25) dans la région de pixels (21), la couche diélectrique tampon (25) dans la zone de plot (22) est également gravée pour former une seconde ouverture (225) exposant une partie d'une surface supérieure de la structure de plot (224), et dans lequel, au même moment où la couche de grille métallique (2141, 2142, 2143, 2144, 2145) est formée sur la couche diélectrique tampon (25) dans la région de pixels (21), une structure de plot (226) est formée sur la couche diélectrique tampon (25) dans la zone de plot (22) de manière à remplir la seconde ouverture (225) et à être électriquement connectée à la partie supérieure exposée de la structure de plot (224).

9. Un dispositif semi-conducteur comprenant :
un substrat (20) avec une région de pixels (21) , le substrat comprenant une tranchée formée dans la région du pixel (21) ;
une structure de remplissage de tranchée (212) formée dans la région du pixel (21) du substrat (20) ;
une couche diélectrique tampon (25) recouvrant la surface du substrat (20) dans la région de pixels (21), la couche diélectrique tampon (25) comprenant une première ouverture (2131, 2132, 2133, 2134) exposant au moins une partie du substrat (20) autour d'une partie supérieure de paroi latérale de la structure de remplissage de tranchée (212), ou exposant à la fois au moins une partie du substrat (20) autour d'une partie supérieure de paroi latérale de la structure de remplissage de tranchée (212) et au moins une partie supérieure de la structure de remplissage de tranchée (212) ; et
une couche de grille métallique (2141, 2142, 2143, 2144, 2145) formée sur la couche diélectrique tampon (25) de manière à remplir la première ouverture (2131, 2132, 2133, 2134) et être électriquement connectée à la partie exposée du substrat (20), ou la couche de grille métallique (2141, 2142, 2143, 2144, 2145) étant électriquement connectée à la fois à la partie exposée du substrat (20) et à la partie exposée de la structure de remplissage de tranchée.

10. Le dispositif semi-conducteur selon la revendication 9, dans lequel la structure de remplissage de tranchée (212) comprend une première couche d'oxyde isolante (2121), une couche diélectrique à constante diélectrique élevée (2122) et une seconde couche d'oxyde isolante (2123), qui sont empilées séquentiellement sur une surface de la tranchée dans le substrat (20), et le matériau de remplissage remplissant la tranchée, la première couche d'oxyde isolante (2121), la couche diélectrique à constante diélectrique élevée (2122) et la seconde couche d'oxyde isolante (2123) étant situées au moins entre la paroi latérale du matériau de remplissage et le substrat (20).

11. Le dispositif semi-conducteur selon la revendication 9, dans lequel la structure de remplissage de tranchée comprend une première couche métallique conductrice (2124), et dans lequel l'exposition d'au moins une partie supérieure de la structure de remplissage de tranchée (212) dans la première ouverture (2131, 2132, 2133, 2134) comprend : l'exposition de la première couche métallique conductrice (2124) au niveau d'une partie supérieure de paroi latérale de la structure de remplissage de tranchée (212) dans la première ouverture (2131, 2132, 2133, 2134) qui est configurée pour entourer la partie supérieure de paroi latérale de la structure de remplissage de tranchée (212) ; et/ou l'exposition d'une partie ou de la totalité d'une surface supérieure de la première couche métallique conductrice (2124) dans la structure de remplissage de tranchée (212) au niveau de la première ouverture (2131, 2132, 2133, 2134) qui se trouve sur une surface supérieure de la structure de remplissage de tranchée (212).

12. Le dispositif semi-conducteur selon la revendication 9, dans lequel la structure de remplissage de tranchée (212) comprend une couche diélectrique à constante diélectrique élevée (2122), la couche diélectrique à constante diélectrique élevée (2122) étant prise en sandwich entre une paroi latérale du matériau de remplissage et le substrat (20), et dans lequel la couche diélectrique à constante diélectrique élevée (2122) a une valeur k supérieure à 7.

13. Le dispositif semi-conducteur selon l'une quelconque des revendications 9 à 12, dans lequel le substrat (20) comporte en outre une zone de plot (22) périphérique à la région de pixels (21), et dans lequel une interconnexion métallique (221) est formée dans la zone de plot (22) du substrat (20) et une structure de plot (224) est formée au-dessus de l'interconnexion métallique (221), la partie inférieure de la structure de plot (224) étant électriquement connectée à l'interconnexion métallique (221).

14. Le dispositif semi-conducteur selon la revendication 13, dans lequel un trou traversant (223) est formé dans la zone de plot (22) du substrat (20), le trou traversant (223) exposant au moins une partie d'une surface supérieure de l'interconnexion métallique (221), et dans lequel la structure de plot (224) comprend une troisième couche d'oxyde isolante (2241) sur une paroi latérale du trou traversant (223) et une troisième couche métallique conductrice (2242) qui remplit le trou traversant (223).

15. Le dispositif semi-conducteur selon la revendication 13, dans lequel la couche diélectrique tampon (25) recouvre en outre la surface du substrat (20) dans la zone de plot (22) et comprend une seconde ouverture (225) exposant au moins une partie supérieure de la structure de plot (224), et dans lequel une structure de plot (226) est formée sur la couche diélectrique tampon (25) dans la zone de plot (22) de manière à remplir la seconde ouverture (225) et à être électriquement connectée à la partie supérieure exposée de la structure de plot (224).
